# EUROPEAN PATENT APPLICATION

(11) **EP 4 686 359 A1**
(43) Date of publication of application: **28.01.2026**
(21) Application number: 25173902.5
(22) Date of filing: 02.05.2025
(51) Int. Cl.: H10K 59/122, H10K 59/124, H10K 59/80

(54) **DISPLAY DEVICE**

(30) Priority: 23.07.2024 KR 20240097067
(71) Applicant: LG Display Co., Ltd., Seoul, 07336 (KR)
(72) Inventor: KIM, Yongmin, 10845 Paju-si (KR); BAEK, JungSun, 10845 Paju-si (KR); LEE, Seongjoo, 10845 Paju-si (KR)
(74) Representative: Ter Meer Steinmeister & Partner

(57) **Abstract**

A display device can include a substrate including a plurality of sub-pixels, a planarization layer disposed on the substrate and including a first opening, an anode disposed in the first opening and on a side portion of the planarization layer in the first opening, a bank covering a part of the anode and including a second opening, an organic layer exposed through the second opening and disposed on the anode, and a cathode disposed on the organic layer. The shape of the first opening is different from that of the second opening.

## Description

This application claims priority to Korean Patent Application No. 10-2024-0097067 filed on July 23, 2024.

### BACKGROUND

### Field

The present disclosure relates to a display device.

### Discussion of the Related Art

Much research is being performed in a field of a display device to improve performances of various display devices, such as reduced thickness, light weight, and low power consumption so that the display device is better able to visually expresses electrical information signals.

Among various display devices, an electroluminescent display device is one that is a self-emitting display device so that a separate light source is not necessary. Such electroluminescent display device is different from a liquid crystal display device that requires a separate structure such as a backlight unit. Therefore, the electroluminescent display device can be manufactured to have light weight and reduced thickness. Since the electroluminescent display device can be driven at a low voltage, it is advantageous not only in terms of power consumption, but also in terms of color implementation, a response speed, a viewing angle, a contrast ratio (CR). Therefore, it is expected to be utilized in various fields going forward.

Meanwhile, light emitted from an emission layer of the electroluminescent display device passes through several components of the electroluminescent display device and exits from the electroluminescent display device. However, some of the light emitted from the emission layer is confined in the electroluminescent display device without being extracted therefrom. Accordingly, a light extraction efficiency of the electroluminescent display device can be decreased.

### SUMMARY OF THE DISCLOSURE

An object to be achieved by the present disclosure is to provide a display device which improves the amount of light extraction.

Another object to be achieved by the present disclosure is to provide a display device which improves a luminance viewing angle and an optical efficiency in a specific direction.

Yet another object to be achieved by the present disclosure is to provide a display device which can control the luminance viewing angle and the optical efficiency according to a viewing angle direction.

At least one of these objects is solved by the features of the independent claims. Objects of the present disclosure are not limited to the above-mentioned objects, and other objects, which are not mentioned above, can be clearly understood by those skilled in the art from the following descriptions.

A display device according to an example embodiment of the present disclosure includes a substrate including a plurality of sub-pixels, a planarization layer disposed over the substrate and including a first opening, an anode disposed in the first opening and on side portions of the planarization layer facing each other in the first opening, a bank covering a part of the anode and including a second opening, an organic layer exposed through the second opening and disposed on the anode and a cathode disposed on the organic layer. Herein, a distance between the anode disposed on the side portion of the planarization layer and a side portion of the bank exposed through the second opening may vary depending on a location within at least one sub-pixel.

Other detailed matters of the example embodiments are included in the detailed description and the drawings.

In the display device according to an example embodiment of the present disclosure, an anode may have a side mirror structure. Thus, it is possible to increase the amount of light extraction of the display device. Therefore, it is possible to implement low power consumption. Further, it is possible to reduce the use of fossil fuels for power generation and thus possible to reduce the emission of greenhouse gases. Accordingly, it is possible to implement ESG (Environment/Social/Governance).

In the display device according to an example embodiment of the present disclosure, a distance between an anode having a side mirror structure and a main emission area may vary within a sub-pixel. Thus, it is possible to improve the luminance viewing angle and the optical efficiency in a specific direction. Therefore, it is possible to control the luminance viewing angle and the optical efficiency according to a viewing angle direction.

When Color On Encapsulation (COE) technology is applied to the present disclosure, the luminance viewing angle is increased in a main viewing angle direction. Therefore, a width of a black matrix in the main viewing angle direction can be reduced, and, thus, an aperture ratio can be improved.

In the display device according to an example embodiment of the present disclosure, color viewing angle characteristics can be improved in all directions of a side display model. Therefore, it is possible to improve a luminance when a bent area is viewed at a normal viewing angle. Thus, it is possible to improve a front luminance and a color uniformity.

The effects according to the present disclosure are not limited to the contents exemplified above, and more various effects are included in the present disclosure.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a diagram schematically illustrating a configuration of a display device according to embodiments of the present disclosure;
FIG. 2 is a plan view schematically illustrating a display panel of FIG. 1;
FIG. 3 is a perspective view illustrating a structure in which a touch panel is embedded in the display panel;
FIG. 4 illustrates a pixel structure in a display panel according to a first embodiment of the present disclosure;
FIG. 5 is a cross-sectional view taken along the line Ia-Ia of FIG. 4;
FIG. 6 is a cross-sectional view taken along the line Ib-Ib of FIG. 4;
FIG. 7 illustrates an emission image of the cross section shown in FIG. 5;
FIG. 8 illustrates an emission image of the cross section shown in FIG. 6;
FIG. 9A is a perspective view illustrating a part of left and right sides of a sub-pixel according to a main viewing angle direction;
FIG. 9B is a perspective view illustrating a part of upper and lower sides of the sub-pixel according to the main viewing angle direction;
FIG. 10A and FIG. 10B are graphs showing a viewing angle-dependent luminance of a red sub-pixel;
FIG. 11A and FIG. 11B are graphs showing a viewing angle-dependent luminance of a green sub-pixel;
FIG. 12A and FIG. 12B are graphs showing a viewing angle-dependent luminance of a blue sub-pixel;
FIG. 13A through FIG. 13C are graphs showing an optical efficiency depending on a separation distance;
FIG. 14 illustrates a pixel structure in a display panel according to a second embodiment of the present disclosure;
FIG. 15 illustrates a pixel structure in a display panel according to a third embodiment of the present disclosure;
FIG. 16 is a partial cross-sectional view of a sub-pixel in a display panel according to a fourth embodiment of the present disclosure;
FIG. 17 is another partial cross-sectional view of the sub-pixel in the display panel according to the fourth embodiment of the present disclosure;
FIG. 18 is a plan view illustrating a part of a sub-pixel structure in a Color On Encapsulation (COE) structure;
FIG. 19A is a graph showing a color coordinate shift amount of white light depending on a viewing angle in an upward direction from the center of a display panel according to a comparative embodiment;
FIG. 19B is a graph showing a color coordinate shift amount of white light depending on a viewing angle in a downward direction from the center of the display panel according to the comparative embodiment;
FIG. 20 illustrates a pixel structure in a display panel according to a fifth embodiment of the present disclosure;
FIG. 21A is a graph showing a color coordinate shift amount of white light depending on a viewing angle in an upward direction from the center of a display panel according to an embodiment;
FIG. 21B is a graph showing a color coordinate shift amount of white light depending on a viewing angle in a downward direction from the center of the display panel according to the embodiment;
FIG. 22 is a perspective view illustrating a display device according to a sixth embodiment of the present disclosure;
FIG. 23A illustrates a pixel structure in the part A of FIG. 22;
FIG. 23B illustrates a pixel structure in the part B of FIG. 22;
FIG. 23C illustrates a pixel structure in the part C of FIG. 22;
FIG. 23D illustrates a pixel structure in the part D of FIG. 22; and
FIG. 24 is a partial cross-sectional view of the sub-pixel in the display panel according to another embodiment of the present disclosure.

### DETAILED DESCRIPTION OF THE EMBODIMENTS

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the disclosure. Further, in the following description of the present disclosure, a detailed explanation of known related technologies can be omitted to avoid unnecessarily obscuring the subject matter of the present disclosure. The terms such as "including," "having," and "consist of" used herein are generally intended to allow other components to be added unless the terms are used with the term "only". Any references to singular can include plural unless expressly stated otherwise.

Components are interpreted to include an ordinary error range even if not expressly stated.

When the position relation between two parts is described using the terms such as "on", "above", "below", and "next", one or more parts can be positioned between the two parts unless the terms are used with the term "immediately" or "directly".

When an element or layer is disposed "on" another element or layer, another layer or another element can be interposed directly on the other element or therebetween.

Although the terms "first", "second", and the like are used for describing various components, these components are not confined by these terms. These terms are merely used for distinguishing one component from the other components. Therefore, a first component to be mentioned below can be a second component in a technical concept of the present disclosure.

Like reference numerals generally denote like elements throughout the disclosure.

A size and a thickness of each component illustrated in the drawing are illustrated for convenience of description, and the present disclosure is not limited to the size and the thickness of the component illustrated.

The term "can" fully encompasses all the meanings and coverages of the term "may."

The term "made of" for an element can fully encompass the meaning of being completely formed of the element, or simply including the element.

The features of various embodiments of the present disclosure can be partially or entirely adhered to or combined with each other and can be interlocked and operated in technically various ways, and the embodiments can be carried out independently of or in association with each other.

Hereinafter, an example embodiment of the present disclosure will be described in detail with reference to the drawings.

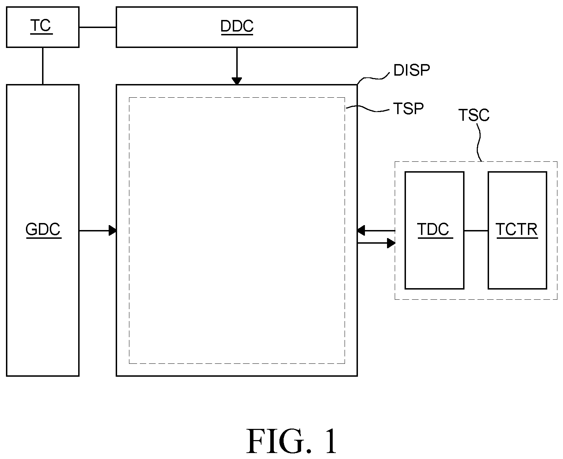

FIG. 1 is a diagram schematically illustrating a configuration of a display device according to embodiments of the present disclosure. All components of each display device according to all embodiments of the present disclosure are operatively coupled and configured.

For example, FIG. 1 illustrates a schematic configuration of a display device in which a touch panel TSP is embedded according to embodiments of the present disclosure. However, the present disclosure is not limited thereto. The display device according to embodiments of the present disclosure can be not equipped with a touch panel.

Referring to FIG. 1, the display device according to embodiments of the present disclosure can provide both a function for displaying images and a function for sensing a touch.

In order to provide an image displaying function, the display device according to embodiments of the present disclosure can include a display panel DISP, a gate driving circuit GDC, a data driving circuit DDC, and a timing controller TC.

For example, in the display panel DISP, a plurality of data lines and a plurality of gate lines are disposed and a plurality of sub-pixels defined by the plurality of data lines and the plurality of gate lines can be disposed.

The data driving circuit DDC drives the plurality of data lines and the gate driving circuit GDC drives the plurality of gate lines. Further, the timing controller TC can control operations of the data driving circuit DDC and the gate driving circuit GDC.

Each of the data driving circuit DDC, the gate driving circuit GDC, and the timing controller TC can be implemented by one or more individual components. In some cases, two or more of the data driving circuit DDC, the gate driving circuit GDC, and the timing controller TC can be integrally implemented as one component. For example, the data driving circuit DDC and the timing controller TC can also be implemented as one integrated circuit chip (IC chip).

In order to provide a touch sensing function, the display device according to embodiments of the present disclosure can include a touch panel TSP and a touch sensing circuit TSC. The touch panel TSP includes a plurality of touch electrodes. The touch sensing circuit TSC supplies a touch driving signal to the touch panel TSP, and detects a touch sensing signal from the touch panel TSP to sense the presence of a touch of a user or a touch position (touch coordinates) in the touch panel TSP based on the detected touch sensing signal.

For example, the touch sensing circuit TSC can include a touch driving circuit TDC and a touch controller TCTR. The touch driving circuit TDC supplies a touch driving signal to the touch panel TSP and detects a touch sensing signal from the touch panel TSP. The touch controller TCTR senses the presence of a touch of a user and/or a touch position in the touch panel TSP based on the touch sensing signal detected by the touch driving circuit TDC. The touch driving circuit TDC can include a first circuit part which supplies the touch driving signal to the touch panel TSP and a second circuit part which detects the touch sensing signal from the touch panel TSP.

For example, the touch driving circuit TDC and the touch controller TCTR can be implemented as separate components or in some cases, can also be integrally implemented as one component.

For example, each of the data driving circuit DDC, the gate driving circuit GDC, and the touch driving circuit TDC can be implemented as one or more ICs. In terms of electrical connection with the display panel DISP, the circuits can be implemented as a Chip On Glass (COG) type, a Chip On Film (COF) type, or a Tape Carrier Package (TCP) type. Further, the gate driving circuit GDC can also be implemented as a Gate In Panel (GIP) type.

For example, each of circuit configurations DDC, GDC, and TC for display driving and circuit configurations TDC and TCTR for touch sensing can be implemented as one or more individual components. In some cases, one or more of circuit configurations DDC, GDC, and TC for display driving and one or more of circuit configurations TDC and TCTR for touch sensing can be functionally integrated to be implemented as one or more components.

For example, the data driving circuit DDC and the touch driving circuit TDC can be integrated into one or more IC chips. When the data driving circuit DDC and the touch driving circuit TDC are integrated into two or more IC chips, each of two or more IC chips can have a data driving function and a touch driving function.

Meanwhile, the display device according to embodiments of the present disclosure can be of various types, such as a light emitting display device or a liquid crystal display device. Hereinafter, for the convenience of description, a light emitting display device will be described as an example of the display device. For example, the display panel DISP can be of various types, such as a light emitting display panel or a liquid crystal display panel. However, in the following description, a light emitting display panel will be described as an example of the display panel DISP for the convenience of description.

Further, as it will be described below, the touch panel TSP can include a plurality of touch electrodes which is applied with a touch driving signal or can detect a touch sensing signal therefrom. Further, the touch panel TSP can include a plurality of touch routing lines for connecting the plurality of touch electrodes to the touch driving circuit TDC.

The touch panel TSP can be provided outside the display panel DISP. For example, the touch panel TSP and the display panel DISP can be separately manufactured to be combined. Such a touch panel TSP is called an external type or an add-on type.

In contrast, the touch panel TSP can be embedded in the display panel DISP. For example, when the display panel DISP is manufactured, a touch sensor structure, such as a plurality of touch electrodes and a plurality of touch routing lines constituting the touch panel TSP, can be formed together with a plurality of electrodes and signal lines for display driving.

Further, the touch panel TSP can also be formed directly on an encapsulation unit of the display panel DISP. For example, a touch insulating film and touch electrodes are patterned on the encapsulation unit and connected to signal lines formed as electrodes for display driving to be driven. Hereinafter, for the convenience of description, an example where the touch panel TSP is formed directly on the encapsulation unit will be described.

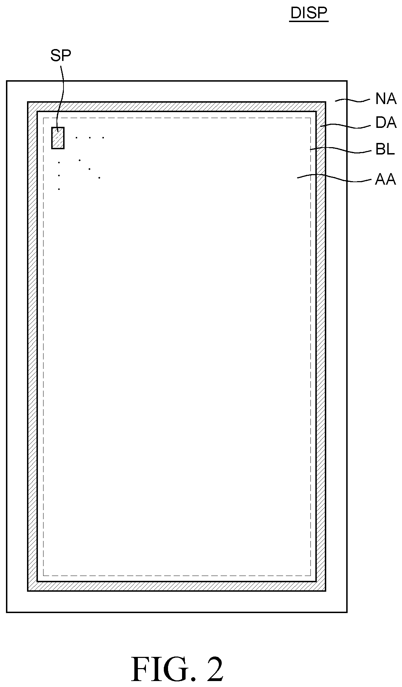

FIG. 2 is a plan view schematically illustrating a display panel of FIG. 1.

Referring to FIG. 2, the display panel DISP can include an active area AA in which images are displayed and a non-active area NA which is an outer area of an outer boundary line BL of the active area AA.

In the active area AA of the display panel DISP, a plurality of sub-pixels SP for displaying images is disposed and various electrodes or signal lines for display driving are disposed.

Further, in the active area AA of the display panel DISP, a plurality of touch electrodes for touch sensing and a plurality of touch routing lines electrically connected to the plurality of touch electrodes can be disposed. Accordingly, the active area AA can also be referred to as a touch sensing area capable of touch sensing.

In the non-active area NA of the display panel DISP, link lines extending from various signal lines disposed in the active area AA or link lines are electrically connected to various signal lines disposed in the active area AA, and pads electrically connected to the link lines can be disposed. The pads disposed in the non-active area NA can be bonded or electrically connected to the display driving circuit.

Further, in the non-active area NA of the display panel DISP, link lines extending from a plurality of touch routing lines disposed in the active area AA or link lines electrically connected to a plurality of touch routing lines disposed in the active area AA, and pads electrically connected to the link lines can be disposed. The pads disposed in the non-active area NA can be bonded or electrically connected to the touch driving circuit.

In the non-active area NA, a part of an outermost touch electrode among a plurality of touch electrodes disposed in the active area AA can be expanded. Alternatively, in the non-active area NA, one or more electrodes (touch electrodes) made of the same material as the plurality of touch electrodes disposed in the active area AA can also be further disposed.

For example, all the plurality of touch electrodes disposed in the display panel DISP can be disposed in the active area AA. Alternatively, some (e.g., an outermost touch electrode) among the plurality of touch electrodes disposed in the display panel DISP can be disposed in the non-active area NA. Otherwise, some (e.g., an outermost touch electrode) among the plurality of touch electrodes disposed in the display panel DISP can also be disposed in both the active area AA and the non-active area NA.

Referring to FIG. 2, the display panel DISP according to embodiments of the present disclosure can include a dam area DA having a dam for suppressing any layer (e.g., the encapsulation unit in the display panel) in the active area AA from passing over the display panel DISP.

The dam area DA can be located at a boundary between the active area AA and the non-active area NA or at any one location of the non-active area NA which is an outer area of the active area AA.

The dam disposed in the dam area DA can be disposed to surround the active area AA in all directions or disposed only outside one or more parts of the active area AA.

The dam disposed in the dam area DA can be composed of one pattern in which all the dams are connected or two or more separated patterns. Further, in the dam area DA, only a primary dam can be disposed, or two or more dams (primary dam and secondary dam) can be disposed, or three or more dams can also be disposed.

For example, in the dam area DA, only the primary dam is disposed in any one direction and both the primary dam and the secondary dam can also be disposed in the other direction.

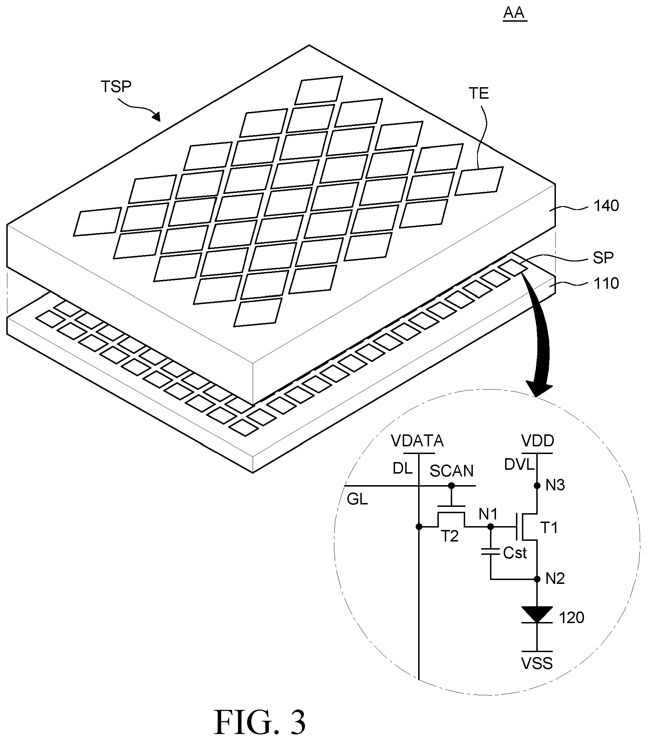

FIG. 3 is a perspective view illustrating a structure in which a touch panel is embedded in a display panel.

FIG. 3 is a perspective view illustrating a structure in which a touch panel is embedded in a display panel according to embodiments of the present disclosure.

Referring to FIG. 3, for example, a plurality of sub-pixels SP can be disposed on a substrate 110 in the active area AA of the display panel (DISP of FIG. 2).

Each sub-pixel SP can include a light emitting diode 120, a first transistor T1 for driving the light emitting diode 120, and a second transistor T2 for transmitting a data voltage VDATA to a first node N1 of the first transistor T1. Each sub-pixel SP can also include a storage capacitor Cst for maintaining a constant voltage for one frame.

For example, the first transistor T1 can include a first node N1 to which the data voltage VDATA is applied, a second node N2 electrically connected to the light emitting diode 120, and a third node N3 to which a driving voltage VDD is applied from a driving voltage line DVL. The first node N1 is a gate node, the second node N2 can be a source node or a drain node, and the third node N3 can be a drain node or a source node. The first transistor T1 can be referred to as a driving transistor which drives the light emitting diode 120.

The light emitting diode 120 can include a first electrode (e.g., an anode), an emission layer, and a second electrode (e.g., a cathode). The first electrode is electrically connected to the second node N2 of the first transistor T1, and the second electrode can be applied with a base voltage VSS.

The emission layer in the light emitting diode 120 can be made of an organic material or an inorganic material.

For example, the second transistor T2 is controlled to be turned on or off by a scan signal SCAN applied through a gate line GL and can be electrically connected between the first node N1 of the first transistor T1 and a data line DL. Further, the second transistor T2 can be referred to as a switching transistor.

For example, when the second transistor T2 is turned on by the scan signal SCAN, the second transistor T2 can transmit the data voltage VDATA supplied from the data line DL to the first node N1 of the first transistor T1.

Further, the storage capacitor Cst can be electrically connected between the first node N1 and the second node N2 of the first transistor T1.

As illustrated in FIG. 3, each sub-pixel SP can have a 2T1C structure including two transistors T1 and T2 and one capacitor Cst. In some cases, each sub-pixel SP can further include one or more transistors or can further include one or more capacitors.

The first transistor T1 and the second transistor T2 can be an n-type transistor or a p-type transistor. As described above, in the display panel DISP, circuit elements, such as the light emitting diode 120, two or more transistors T1 and T2, and one or more capacitors Cst, can be disposed. The circuit elements (specifically, the light emitting diode 120) are vulnerable to external moisture or oxygen. Thus, an encapsulation unit 140 for suppressing the permeation of the external moisture or oxygen into the circuit elements can be disposed on the display panel DISP.

The encapsulation unit 140 can be composed of one layer, or can also be composed of a plurality of layers.

Meanwhile, in the display device according to embodiments of the present disclosure, the touch panel TSP can be disposed on the encapsulation unit 140. For example, in the display device according to embodiments of the present disclosure, a touch sensor structure, such as a plurality of touch electrodes TE which constitutes the touch panel TSP, can be disposed on the encapsulation unit 140.

Further, the display device according to embodiments of the present disclosure can sense a touch based on capacitance formed in the touch electrode TE.

The display device according to embodiments of the present disclosure employs a capacitance-based touch sensing manner. Thus, it can sense a touch by a mutual-capacitance-based touch sensing manner or a self-capacitance-based touch sensing manner.

For example, according to the mutual-capacitance-based touch sensing manner, a plurality of touch electrodes TE can be classified into a driving touch electrode (a transmission touch electrode) and a sensing touch electrode (a reception touch electrode). The driving touch electrode is applied with a touch driving signal. The sensing touch electrode detects a touch sensing signal and forms a capacitance with the driving touch electrode.

In the case of the mutual-capacitance-based touch sensing manner, the touch sensing circuit can sense the presence of a touch and/or the touch coordinates based on a change in capacitance (mutual-capacitance) between the driving touch electrode and the sensing touch electrode depending on the presence of a pointer, such as a finger or a pen.

According to the self-capacitance-based touch sensing manner, each touch electrode TE serves as both a driving touch electrode and a sensing touch electrode. For example, the touch sensing circuit applies a touch driving signal to one or more touch electrodes TE, and detects a touch sensing signal by means of the touch electrode TE applied with the touch driving signal. Thus, the touch sensing circuit can identify a change in capacitance between a pointer, such as a finger or a pen, and the touch electrode TE based on the detected touch sensing signal. Therefore, the touch sensing circuit can sense the presence of a touch and/or the touch coordinates. In the case of the self-capacitance-based touch sensing manner, the driving touch electrode and the sensing touch electrode are not distinguished.

As described above, the display device according to embodiments of the present disclosure can sense a touch by the mutual-capacitance-based touch sensing manner or the self-capacitance-based touch sensing manner. However, in the following description, for the convenience of description, the display device will be described as performing mutual-capacitance-based touch sensing and having a touch sensor structure therefor as an example.

Hereinafter, a configuration of a sub-pixel will be described in detail with reference to the accompanying drawings.

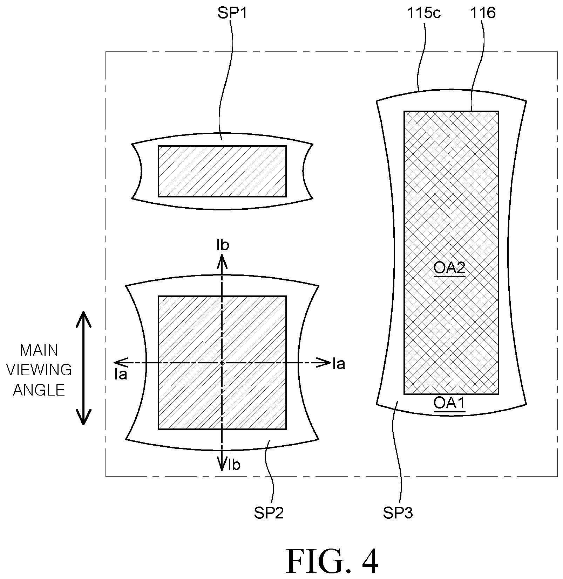

FIG. 4 illustrates a pixel structure in a display panel according to a first embodiment of the present disclosure.

FIG. 4 illustrates a part of a display panel in which three sub-pixels SP1, SP2 and SP3 are disposed. Further, FIG. 4 illustrates a bank 116 including a second opening OA2 as a main emission area and a third planarization layer 115c on which an anode having a side mirror structure is disposed.

FIG. 4 illustrates a pixel structure in a display panel whose main viewing angle direction is an upward and downward direction. For reference, the main viewing angle of the display refers to a viewing angle at which the optimum image quality can be maintained while a user views the screen. For example, a horizontal viewing angle refers to an angle at which the image quality is maintained when the screen is inclined in a left and right direction. As the horizontal viewing angle increases, a color distortion or luminance decrease can be reduced even when the user views the screen from the side. A vertical viewing angle refers to an angle at which the image quality is maintained when the screen is inclined in the upward and downward direction. As the vertical viewing angle increases, a color distortion or luminance decrease can be reduced even when the user views the screen from above or below.

Referring to FIG. 4, the display panel according to the first embodiment of the present disclosure can include a pixel area in which a plurality of sub-pixels SP1, SP2 and SP3 is disposed, and a line area in which various signal lines are disposed.

A plurality of first sub-pixels SP1, second sub-pixels SP2 and third sub-pixels SP3 can be disposed in the pixel area.

For example, the first sub-pixels SP1 can be red sub-pixels.

For example, the second sub-pixels SP2 can be green sub-pixels.

For example, the third sub-pixels SP3 can be blue sub-pixels.

For example, each of the first sub-pixels SP1, the second sub-pixels SP2, and the third sub-pixels SP3 can have a polygonal shape, such as a rectangular shape, but is not limited thereto.

Herein, the shape of the sub-pixels SP1, SP2 and SP3 can be defined by the shape of the second opening OA2. However, the present disclosure is not limited thereto.

FIG. 4 illustrates an example where a first sub-pixel SP1, a second sub-pixel SP2, and a third sub-pixel SP3 are gathered to form a pixel. However, the present disclosure is not limited thereto.

Meanwhile, according to the present disclosure, a side mirror (SM) structure of the anode adds a reflective emission area in addition to the main emission area. Thus, each emission area can be expanded as compared to each of the sub-pixels SP1, SP2 and SP3. Detailed description of the SM structure will be made below.

Meanwhile, as shown in FIG. 4, the third planarization layer 115c on which the anode having an SM structure is disposed can include a first opening OA1 provided by removing (opening) a portion corresponding to the main emission area, the reflective emission area, and a first non-emission area of the sub-pixels SP1, SP2 and SP3.

Further, in the first embodiment of the present disclosure, a side portion of the third planarization layer 115c in contact with a side surface of the anode having an SM structure has a shape that differs between its left and right sides and its upper and lower sides when viewed from the top. Thus, it is possible to improve a luminance viewing angle and an optical efficiency in a specific direction. For example, a distance between the anode having an SM structure and the main emission area within each of the sub-pixels SP1, SP2 and SP3, i.e., a distance between a side portion of the anode and a side portion of the bank 116, varies depending on a viewing angle direction to improve the luminance viewing angle and the optical efficiency in a specific direction. Further, it is possible to control the luminance viewing angle and the optical efficiency according to the viewing angle direction. For example, the distance between the side portion of the anode and the side portion of the bank 116 is shortened in a direction parallel to the main viewing angle direction. Thus, it is possible to maximize the improvement of the luminance viewing angle. Further, the distance between the side portion of the anode and the side portion of the bank 116 is increased in a direction perpendicular to the main viewing angle direction. Thus, it is possible to maximize the improvement of the optical efficiency. In this case, for example, a left and right width of the first opening OA1 is the smallest at the center and gradually increases in the upward and downward direction when viewed from the top. Further, an upper and lower width of the first opening OA1 is the greatest at the center and gradually decreases in the left and right direction when viewed from the top. Therefore, the left and right sides of the first opening OA1 can have an inwardly concave shape, whereas the upper and lower sides of the first opening OA1 can have an outwardly convex shape.

As described above, according to the present disclosure, the distance between the side portion of the anode and the side portion of the bank 116 varies depending on the viewing angle direction within each of the sub-pixels SP1, SP2 and SP3. The amount of light extraction increased by the SM structure can be controlled by an increase in luminance viewing angle and/or optical efficiency depending on the viewing angle direction.

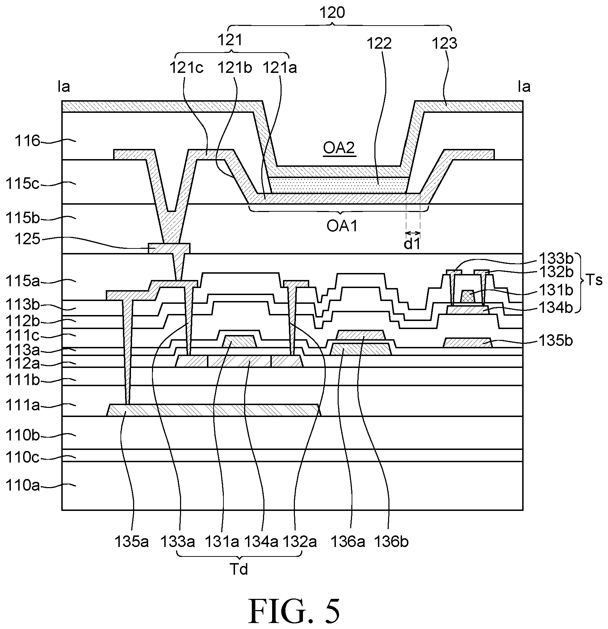

FIG. 5 is a cross-sectional view taken along the line Ia-Ia of FIG. 4.

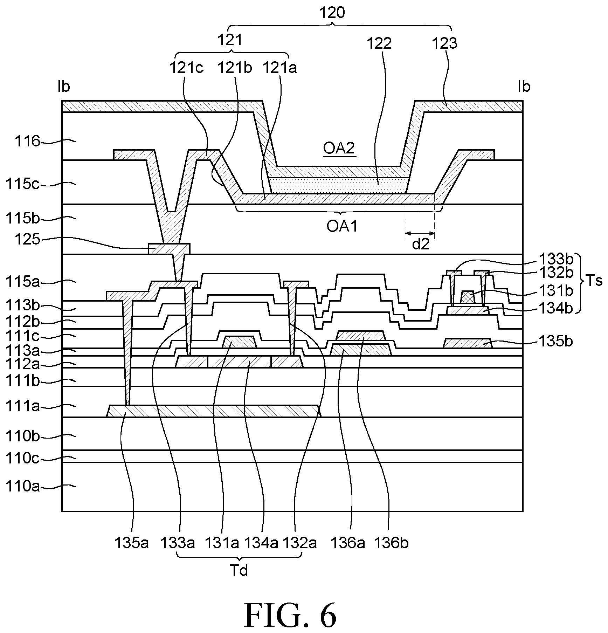

FIG. 6 is a cross-sectional view taken along the line Ib-Ib of FIG. 4.

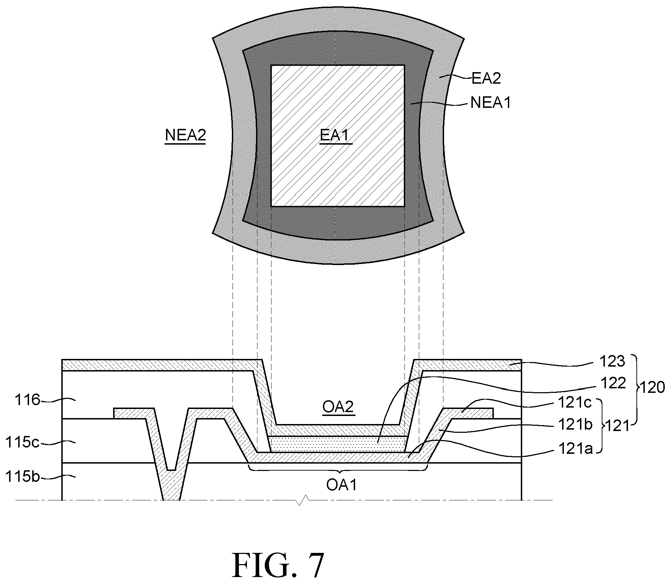

FIG. 7 illustrates an emission image of the cross section shown in FIG. 5.

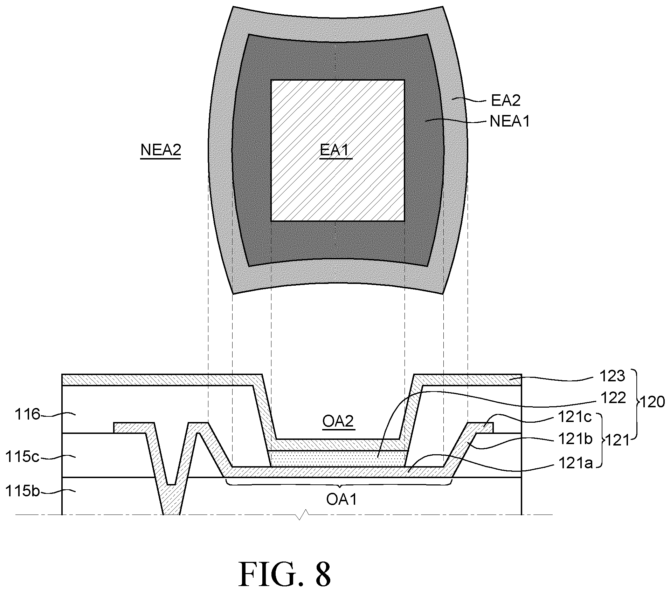

FIG. 8 illustrates an emission image of the cross section shown in FIG. 6.

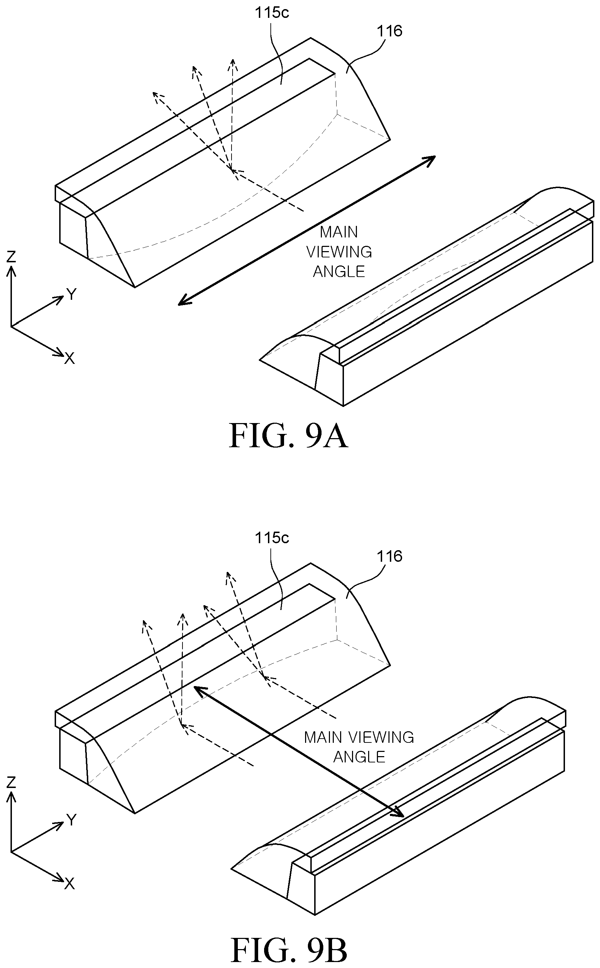

FIG. 9A is a perspective view illustrating a part of left and right sides of a sub-pixel according to a main viewing angle direction.

FIG. 9B is a perspective view illustrating a part of upper and lower sides of the sub-pixel according to the main viewing angle direction.

FIG. 5 and FIG. 6 are cross-sectional views each illustrating a part of a sub-pixel of the display panel according to the first embodiment of the present disclosure. For example, FIG. 5 illustrates a part of a cross-section of the center of the second sub-pixel SP2 of FIG. 4 as taken along the left and right direction. Further, FIG. 6 illustrates a part of a cross-section of the center of the second sub-pixel SP2 of FIG. 4 as taken along the upward and downward direction.

Referring to FIG. 5 and FIG. 6, the sub-pixel can include an encapsulation layer, a touch sensor layer and/or a color filter layer and a black matrix on the light emitting element 120. But is not limited thereto.

FIG. 7 and FIG. 8 illustrate a part of a cross-section of a sub-pixel of the display panel according to the first embodiment of the present disclosure as taken along the left and right direction and the upward and downward direction. Further, FIG. 7 and FIG. 8 illustrate emission images corresponding thereto. For example, FIG. 7 illustrates a part of a cross-section of the center of the second sub-pixel SP2 of FIG. 4 as taken along the left and right direction and an emission image corresponding thereto. Further, FIG. 8 illustrates a part of a cross-section of the center of the second sub-pixel SP2 of FIG. 4 as taken along the upward and downward direction and an emission image corresponding thereto. FIG. 7 and FIG. 8 can include components disposed on and under the light emitting element 120. However, the present disclosure is not limited thereto. Hereinafter, the left and right direction and the upward and downward direction will be described based on the second sub-pixel SP2 of FIG. 4.

FIG. 9A illustrates an edge profile of the bank 116 and the third planarization layer 115c in a part of the sub-pixel along the left and right direction. Further, FIG. 9B illustrates an edge profile of the bank 116 and the third planarization layer 115c in a part of the sub-pixel along the upward and downward direction.

Referring to FIG. 5, FIG. 9A and FIG. 9B, a driving transistor Td, a switching transistor Ts, and the light emitting element 120 can be disposed on a substrate 110, e.g a substrate including substrates 110a, 110b and 110c.

For example, the substrate 110 may include a first substrate 110a, a second substrate 110b, and an interlayer insulating film 110c. The interlayer insulating film 110c can be disposed between the first substrate 110a and the second substrate 110b. However, the substrate 110 may also be a single substrate.

As described above, the substrate 110 may be composed of the first substrate 110a, the second substrate 110b, and the interlayer insulating film 110c. Thus, it is possible to suppress the permeation of moisture. For example, the substrate 110, or the first substrate 110a and the second substrate 110b can be polyimide (PI) substrates, but are not limited thereto.

A plurality of transistors, such as the driving transistor Td and the switching transistor Ts, can be disposed on the substrate 110, i.e. on the substrates 110a, 110b and 110c.

A multi-buffer layer 111a can be disposed on the substrate 110 (e.g. the second substrate 110b), and an active buffer layer 111b can be disposed on the multi-buffer layer 111a.

Meanwhile, a first light shielding layer 135a can be disposed on the substrate 110, e.g. on the second substrate 110b. However, the present disclosure is not limited thereto, and the first light shielding layer 135a can be disposed on the multi-buffer layer 111a.

The first light shielding layer 135a can serve to shield light.

The multi-buffer layer 111a can be disposed on the first light shielding layer 135a.

The active buffer layer 111b can be disposed on the multi-buffer layer 111a.

A first active layer 134a of the driving transistor Td can be disposed on the active buffer layer 111b.

A first gate insulating film 112a can be disposed on the first active layer 134a.

Further, a first gate electrode 131a of the driving transistor Td can be disposed on the first gate insulating film 112a.

Further, for example, a gate material layer 136a can be disposed on the first gate insulating film 112a at a location different from a location where the driving transistor Td is disposed. For example, the gate material layer 136a can be a first storage electrode, but is not limited thereto.

A first interlayer insulating film 113a can be disposed on the first gate electrode 131a.

A metal layer 136b can be disposed on the first interlayer insulating film 113a. For example, the metal layer 136b can be a second storage electrode, but is not limited thereto.

In this case, the metal layer 136b can constitute a storage capacitor together with the gate material layer 136a. However, the present disclosure is not limited thereto.

Further, for example, a second light shielding layer 135b can be disposed on the first interlayer insulating film 113a at a location different from a location where the metal layer 136b is disposed.

A buffer layer 111c can be disposed on the metal layer 136b and the second light shielding layer 135b.

A second active layer 134b of the switching transistor Ts can be disposed on the buffer layer 111c.

A second gate insulating film 112b can be disposed on the second active layer 134b.

Further, a second gate electrode 131b of the switching transistor Ts can be disposed on the second gate insulating film 112b.

A second interlayer insulating film 113b can be disposed on the second gate electrode 131b.

A first source electrode 132a and a first drain electrode 133a of the driving transistor Td can be disposed on the second interlayer insulating film 113b. Further, a second source electrode 132b and a second drain electrode 133b of the switching transistor Ts can be disposed on the second interlayer insulating film 113b.

In this case, for example, the first source electrode 132a and the first drain electrode 133a can be electrically connected to one side and the other side, respectively, of the first active layer 134a through contact holes formed in the second interlayer insulating film 113b, the second gate insulating film 112b, the buffer layer 111c, the first interlayer insulating film 113a, and the first gate insulating film 112a.

Further, for example, a part of the first drain electrode 133a can be electrically connected to one side of the first light shielding layer 135a through a contact hole formed in the second interlayer insulating film 113b, the second gate insulating film 112b, the buffer layer 111c, the first interlayer insulating film 113a, the first gate insulating film 112a, the active buffer layer 111b, and the multi-buffer layer 111a.

Further, for example, the second source electrode 132b and the second drain electrode 133b can be electrically connected to one side and the other side, respectively, of the second active layer 134b through contact holes formed in the second interlayer insulating film 113b and the second gate insulating film 112b.

A portion of the first active layer 134a overlapping the first gate electrode 131a serves as a channel region. For example, one of the first source electrode 132a and the first drain electrode 133a can be connected to one side of the channel region of the first active layer 134a. Further, the other can be connected to the other side of the channel region of the first active layer 134a.

Further, a portion of the second active layer 134b overlapping the second gate electrode 131b serves as a channel region. For example, one of the second source electrode 132b and the second drain electrode 133b can be connected to one side of the channel region of the second active layer 134b. Further, the other can be connected to the other side of the channel region of the second active layer 134b.

A protection film can be disposed on the first source electrode 132a and the first drain electrode 133a as well as on the second source electrode 132b and the second drain electrode 133b.

Planarization layers 115a and 115b can be disposed on the first source electrode 132a and the first drain electrode 133a as well as on the second source electrode 132b and the second drain electrode 133b. For example, the planarization layers 115a and 115b can include a first planarization layer 115a and a second planarization layer 115b.

The first planarization layer 115a can be disposed on the protection film.

A connection electrode 125 can be disposed on the first planarization layer 115a.

For example, the connection electrode 125 can be electrically connected to one of the first source electrode 132a and the first drain electrode 133a through a contact hole formed in the first planarization layer 115a.

The second planarization layer 115b can be disposed on the connection electrode 125.

The third planarization layer 115c can be disposed on the second planarization layer 115b.

The third planarization layer 115c can be made of an organic material, such as acrylic-based resin or epoxy-based resin. For example, the third planarization layer 115c can be made of photo acryl (PAC). The third planarization layer 115c can also be referred to a planarization layer.

For example, the third planarization layer 115c can include the first opening OA1 provided by removing (opening) a portion corresponding to a first or main emission area EA1, a second or reflective emission area EA2, and a first non-emission area NEA1 of the sub-pixel.

When viewed from the top, the first opening OA1 can have an approximately (or overall) polygonal shape, such as a rectangular shape, whose left and right width is the smallest at the center and gradually increases in the upward and downward direction and whose upper and lower width is the greatest at the center and gradually decreases in the left and right direction (see FIG. 7 and FIG. 8). Therefore, the left and right sides of the first opening OA1 can have an inwardly concave shape, whereas the upper and lower sides of the first opening OA1 can have an outwardly convex shape (see FIG. 9A and FIG. 9B).

The third planarization layer 115c can include a top surface and a side portion.

The top surface of the third planarization layer 115c is the uppermost surface of the third planarization layer 115c, and can be substantially parallel to the substrate 110, i.e. to the second substrate 110b.

Further, the side portion of the third planarization layer 115c can be a surface extending from the top surface to a side surface of the third planarization layer 115c. For example, the side portion of the third planarization layer 115c can include a taper having a predetermined angle. For example, the side portion of the third planarization layer 115c can include a taper having an angle of 30° to 65°. However, the present disclosure is not limited thereto.

The side portion of the third planarization layer 115c can have an approximately (or overall) polygonal shape, such as a rectangular shape, whose left and right width is the smallest at the center and gradually increases in the upward and downward direction and whose upper and lower width is the greatest at the center and gradually decreases in the left and right direction (see FIG. 7 and FIG. 8) when viewed from the top in the same manner as an edge of the first opening OA1. Therefore, the left and right sides of the side portion of the third planarization layer 115c can have an inwardly concave shape, whereas the upper and lower sides of the side portion of the third planarization layer 115c can have an outwardly convex shape (see FIG. 9A and FIG. 9B).

For example, an anode 121 can be disposed on a part of the top surface and the side portion of the third planarization layer 115c and a part of a top surface of the second planarization layer 115b. For example, the anode 121 can be disposed in the first opening OA1 and on a part of the top surface and the side portion of the third planarization layer 115c. Further, for example, the anode 121 disposed in the first opening OA1 can be in contact with the top surface of the second planarization layer 115b.

For example, the anode 121 can include a first area 121a which is disposed in the first opening OA1 and whose surface is substantially parallel to a surface of the substrate 110 (the second substrate 110b). Further, the anode 121 can include a second area 121b which extends from the first area 121a and whose surface has a predetermined angle with respect to the substrate 110 (the second substrate 110b). Herein, for example, the first area 121a of the anode 121 can correspond to the first opening OA1. For example, the second area 121b of the anode 121 can correspond to the side portion of the third planarization layer 115c. Thus, the second area 121b of the anode 121 can also be referred to as a side portion of the anode 121.

According to the present disclosure, the second area 121b of the anode 121 has a side mirror shape and thus can constitute an SM structure. In this case, the SM structure of the anode 121 can be provided within the first opening OA1. For example, the SM structure of the anode 121 can form the reflective emission area EA2. In this case, for example, the reflective emission area EA2 follows an outline of the main emission area EA1. Further, when the light emitting element 120 emits light, the reflective emission area EA2 is shown as a continuous rectangular annular emission image or a discontinuous rectangular annular emission image. The annular shape of the reflective emission area EA2 can have the smallest width at a corner of the main emission area EA1, and the first non-emission area NEA1 can have the greatest width at the corner of the main emission area EA1. However, the present disclosure is not limited thereto. When the first opening OA1 has a polygonal shape, the reflective emission area EA2 can be shown as a polygonal annular emission image corresponding in shape to the first opening OA1. When the reflective emission area EA2 is shown as a discontinuous rectangular annular emission image, it can have a discontinuous shape surrounding the outline of the main emission area EA1. For example, the annular shape of the reflective emission area EA2 can decrease in width or can be discontinuous as it gets closer to the corner of the main emission area EA1. A portion where the annular shape of the reflective emission area EA2 decreases in width or is discontinuous can have a greater width of the first non-emission area NEA1 than the other portion. This portion can show a lower luminance than a portion where the main emission area EA1 or the reflective emission area EA2 is continuous as the amount of light emitted from the light emitting element 120 and reflected from the SM structure decreases. The SM structure of the anode 121 causes an increase in the amount of light extraction. Thus, it is possible to improve the luminance viewing angle and the optical efficiency. Meanwhile, the increase in the amount of light extraction facilitates low power consumption. Therefore, it is possible to reduce the use of fossil fuels for power generation and thus possible to reduce the emission of greenhouse gases. Accordingly, it is possible to implement ESG (Environment/Social/Governance). Further, the SM structure of the anode 121 is effective in improving the luminance viewing angles in all directions.

Directing an increased amount of extracted light primarily forward can enhance the optical efficiency, while directing it diagonally can improve the luminance viewing angle.

According to the first embodiment of the present disclosure, the left and right sides of the side portion of the third planarization layer 115c have an inwardly concave shape and the upper and lower sides thereof have an outwardly convex shape. Thus, the left and right sides of the second area 121b of the anode 121 deposited thereon can also have an inwardly concave shape and the upper and lower sides thereof can have an outwardly convex shape. Therefore, the reflective emission area EA2 can have an approximately (or overall) rectangular annular shape whose left and right sides have an inwardly concave shape and upper and lower sides have an outwardly convex shape when viewed from the top. However, the present disclosure is not limited thereto. When the first opening OA1 has a polygonal shape, the reflective emission area EA2 can have a polygonal annular shape corresponding in shape to the first opening OA1.

As described above, according to the first embodiment of the present disclosure, a distance (d1, d2: a separation distance) between the second area 121b of the anode 121 having an SM structure and the main emission area varies within a sub-pixel. For example, a first distance d1 between the second area 121b of the anode 121 and the main emission area at the center of the sub-pixel in the left and right direction can be smaller than a second distance d2 between the second area 121b of the anode 121 and the main emission area at the center of the sub-pixel in the upward and downward direction. For example, a distance between the second area 121b of the anode 121 and the main emission area at the center of the sub-pixel in the left and right direction is the smallest, and referred to as the first distance d1. Further, the distance gradually increases in the upward and downward direction. For example, a distance between the second area 121b of the anode 121 and the main emission area at the center of the sub-pixel in the upward and downward direction is the greatest, and referred to as the second distance d2. Further, the distance gradually decreases in the left and right direction.

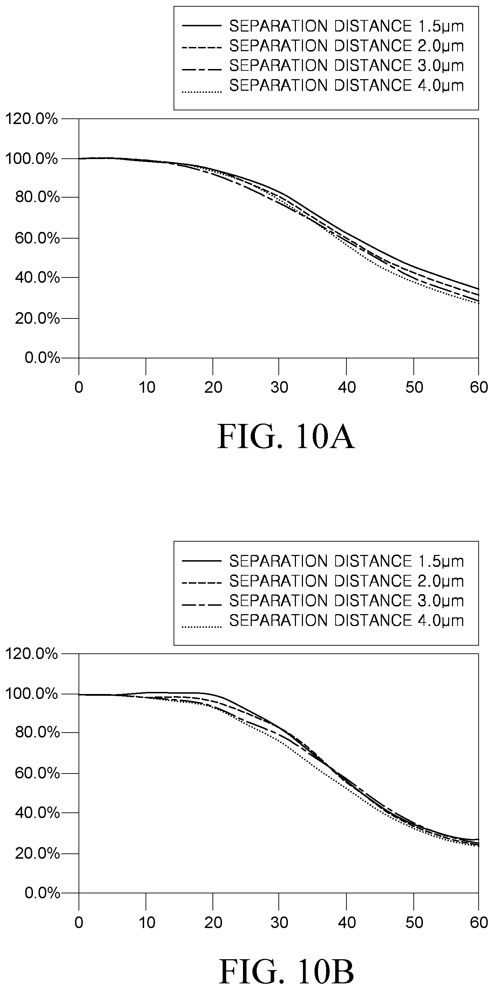

As described above, directing an increased amount of extracted light primarily forward can enhance the optical efficiency, while directing it diagonally can improve the luminance viewing angle. Further, an increased amount of extracted light can be directed forward or diagonally depending on a distance between the second area 121b of the anode 121 having an SM structure and the main emission area. Thus, the distance between the second area 121b of the anode 121 and the main emission area is shortened in a direction parallel to the main viewing angle direction of the sub-pixel. Therefore, it is possible to maximize the improvement of the luminance viewing angle (see FIG. 5, FIG. 7, and FIG. 9A). Further, the distance between the second area 121b of the anode 121 and the main emission area is increased in a direction perpendicular to the main viewing angle direction. Therefore, it is possible to maximize the improvement of the optical efficiency (see FIG. 6, FIG. 8, and FIG. 9B). In this case, the left and right sides of the side portion of the third planarization layer 115c having an inwardly concave shape direct reflected light diagonally. Thus, it is possible to contribute to the improvement of the luminance viewing angle. Referring to FIG. 9A, for example, light in the (x, z) plane can be reflected from the second area 121b of the anode 121 having an SM structure, added with a Y-axis directionality and then directed toward the outside (toward a side surface of the display panel DISP). Further, the upper and lower sides of the side portion of the third planarization layer 115c having an outwardly convex shape gather reflected light toward the inside (toward a front surface of the display panel DISP). Thus, it is possible to contribute to the increase of the optical efficiency. Referring to FIG. 9B, for example, light in the (x, z) plane can be reflected from the second area 121b of the anode 121 having an SM structure, added with a Y-axis directionality and then directed toward the inside. Thus, it is possible to improve the luminance viewing angle and the optical efficiency in a specific direction. Therefore, it is possible to control the luminance viewing angle and the optical efficiency according to a viewing angle direction. This will be described in more detail with reference to FIGS. 10A and 10B, FIGS. 11A and 11B, FIGS. 12A and 12B, and FIGS. 13A through 13C.

As described above, the SM structure provided in the first opening OA1 forms the reflective emission area EA2. Thus, some of light emitted from the light emitting element 120 is reflected from the second area 121b of the anode 121 by the SM structure. Therefore, the reflective emission area EA2 having a rectangular annular shape is formed. Accordingly, the amount of light extraction can be increased. However, the present disclosure is not limited thereto. When the first opening OA1 has a polygonal shape, the reflective emission area EA2 can have a polygonal annular shape corresponding in shape to the first opening OA1.

Further, for example, the left and right sides of an edge of the reflective emission area EA2 can have an inwardly concave shape corresponding in shape to the side portion of the third planarization layer 115c and the second area 121b of the anode 121. Further, the upper and lower sides of the edge of the reflective emission area EA2 can have an outwardly convex shape. Therefore, it is possible to improve the luminance viewing angle and the optical efficiency simultaneously. Further, it is possible to further improve the luminance viewing angle in the main viewing angle direction.

For example, in the first embodiment of the present disclosure, the first or main emission area EA1 can have an approximately rectangular shape. Further, the first non-emission area NEA1 can be shown as an approximately rectangular annular emission image surrounding the main emission area EA1. For example, the inside of the first non-emission area NEA1 can have a rectangular shape surrounding the main emission area EA1. Further, the left and right sides of the outside can have an inwardly concave shape and the upper and lower sides of the outside can have an outwardly convex shape. However, the present disclosure is not limited thereto. When the sub-pixel or the main emission area EA1 has a polygonal shape, the first non-emission area NEA1 can be shown as a polygonal annular emission image corresponding in shape to the sub-pixel or the main emission area EA1. Further, for example, the reflective emission area EA2 can be shown as an emission image having a polygonal annular shape including a rectangular shape. Further, the left and right sides of the reflective emission area EA2 can have an inwardly concave shape and the upper and lower sides thereof can have an outwardly convex shape.

Referring back to FIG. 5 through FIGS. 9A and 9B, the anode 121 can include a third area 121c which extends from the second area 121b and whose surface is substantially parallel to the surface of the substrate 110 (the second substrate 110b). The third area 121c can correspond to the top surface of the third planarization layer 115c.

As described above, within a sub-pixel, the second planarization layer 115b and the third planarization layer 115c can include at least one contact hole spaced apart from the first opening OA1. Further, the driving transistor Td can be electrically connected to the anode 121 through the contact hole.

The bank 116 can be disposed to cover the anode 121.

The bank 116 can cover the second area 121b and the third area 121c of the anode 121. Further, the bank 116 can cover a part of the first area 121a of the anode 121. For example, the bank 116 can cover a part of an edge of the first area 121a of the anode 121. In this case, a distance between the second area 121b of the anode 121 and the main emission area can be regulated depending on the degree of covering a part of the edge of the first area 121a of the anode 121 by the bank 116. Alternatively, a distance between the side portion of the anode 121 and the side portion of the bank 116 can be regulated depending on the degree of covering a part of the edge of the first area 121a of the anode 121 by the bank 116.

A portion of the bank 116 can be opened corresponding to an emission area of the sub-pixel.

For example, the bank 116 can include the second opening OA2 provided by removing (opening) a portion corresponding to the main emission area EA1 of each sub-pixel. For example, the first opening OA1 can have a greater width and a greater area than the second opening OA2. Further, for example, the second opening OA2 can have a rectangular shape, when viewed from the top, but is not limited thereto. The second opening OA2 of the present disclosure can have various shapes, such as a circular shape or an oval shape.

Meanwhile, the main emission area EA1 can correspond in shape to the second opening OA2. The correspondence of the shape of an element to the shape of another element can mean that the shape of the element is an identical shape to another element, two elements have an identical shape, but have different sizes from each other, or the shape of the element can be formed by transferring the shape of another element by some method. Accordingly, the shape of the main emission area EA1 can mean that the shape of the second opening OA2 is substantially transferred by light emitted from an organic layer 122 located in the second opening OA2.

The reflective emission area EA2 does not overlap the main emission area EA1 and can be located to surround the main emission area EA1.

Sub-pixels can be distinguished by the main emission area EA1.

Next, the bank 116 can include a top surface, a side portion, and a bottom surface portion.

For example, the top surface of the bank 116 is the uppermost surface of the bank 116, and can be substantially parallel to the substrate 110 (the second substrate 110b). Further, the top surface of the bank 116 can correspond to the top surface of the third planarization layer 115c.

The side portion of the bank 116 can be a surface extending from the top surface to a side surface of the bank 116. The side portion of the bank 116 can include a taper having a predetermined angle. For example, the side portion of the bank 116 can include a taper having an angle of 30° to 65°. However, the present disclosure is not limited thereto. The side portion of the bank 116 can correspond to the side portion of the third planarization layer 115c.

Further, for example, the bottom surface portion of the bank 116 can correspond to a surface in contact with the anode 121 in the first area 121a of the anode 121. Further, the bottom surface portion of the bank 116 can correspond to a non-emission area NEA between the main emission area EA1 and the reflective emission area EA2.

The first opening OA1 provided in the third planarization layer 115c can have a greater width and a greater area than the second opening OA2 provided in the bank 116. Therefore, the second opening OA2 can be located within the first opening OA1.

For example, a part of the first area 121a of the anode 121 can be exposed through the second opening OA2.

The bank 116 can be made of a PI-based material, but is not limited thereto.

The side portion of the bank 116 can have a rectangular shape in substantially the same manner as an edge of the second opening OA2, but is not limited thereto. For example, the side portion of the bank 116 of the present disclosure can have various shapes, such as a circular shape or an oval shape.

For example, the organic layer 122 can be disposed within and around the second opening OA2 of the bank 116. For example, the organic layer 122 can be disposed on the first area 121a of the anode 121 exposed through the second opening OA2 of the bank 116. For example, the organic layer 122 can be disposed within the second opening OA2 of the bank 116.

The organic layer 122 can be disposed only within the second opening OA2, but the present disclosure is not limited thereto. A part of the organic layer 122 can be disposed on the top surface and the side portion of the bank 116 as well as within the second opening OA2.

A cathode 123 can be disposed on the organic layer 122.

The light emitting element 120 can be composed of the anode 121, the organic layer 122, and the cathode 123.

For example, the main emission area EA1 can be formed by the light emitting element 120 provided in the second opening OA2.

An encapsulation layer can be located on the light emitting element 120.

The encapsulation layer can have a single layer structure or a multi-layer structure. For example, the encapsulation layer can include a first encapsulation layer, a second encapsulation layer, and a third encapsulation layer.

For example, the first encapsulation layer and the third encapsulation layer can be composed of inorganic films, and the second encapsulation layer can be composed of an organic film. For example, among the first encapsulation layer, the second encapsulation layer, and the third encapsulation layer, the second encapsulation layer is the thickest. Thus, the second encapsulation layer can serve as a planarization layer.

The first encapsulation layer can be made of an inorganic insulating material which can be subjected to low temperature deposition. For example, the first encapsulation layer can be made of silicon nitride (SiNx), silicon oxide (SiOx), silicon oxynitride (SiON), or aluminum oxide (Al₂O₃). But is not limited thereto.

The second encapsulation layer can be formed to have a smaller area than the first encapsulation layer. In this case, the second encapsulation layer can be formed to expose both ends of the first encapsulation layer. But is not limited thereto.

Further, for example, the second encapsulation layer can be made of an organic insulating material, such as acrylic resin, epoxy resin, polyimide, polyethylene, or silicon oxy carbon (SiOC). But is not limited thereto. Furthermore, for example, the second encapsulation layer can be formed by an inkjet method, but is not limited thereto.

The third encapsulation layer can be formed to cover a top surface and a side surface of each of the second encapsulation layer and the first encapsulation layer.

For example, the third encapsulation layer can minimize or block the permeation of external moisture or oxygen into the first encapsulation layer and the second encapsulation layer. Further, for example, the third encapsulation layer can be made of an inorganic insulating material, such as silicon oxide (SiOx), silicon oxynitride (SiON), aluminum oxide (Al₂O₃), or silicon nitride (SiNx), but is not limited thereto.

A touch sensor layer can be disposed on the encapsulation layer described above.

FIG. 10A and FIG. 10B are graphs showing a viewing angle-dependent luminance of a red sub-pixel.

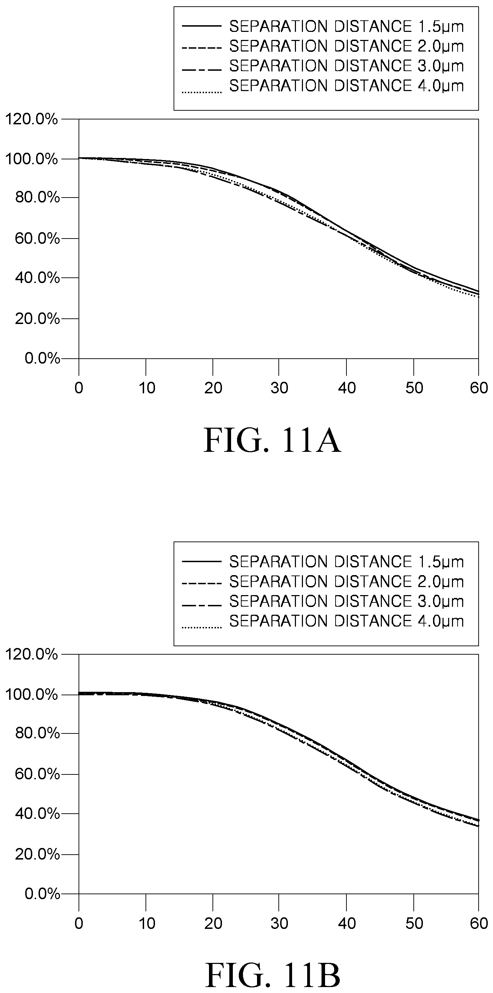

FIG. 11A and FIG. 11B are graphs showing a viewing angle-dependent luminance of a green sub-pixel.

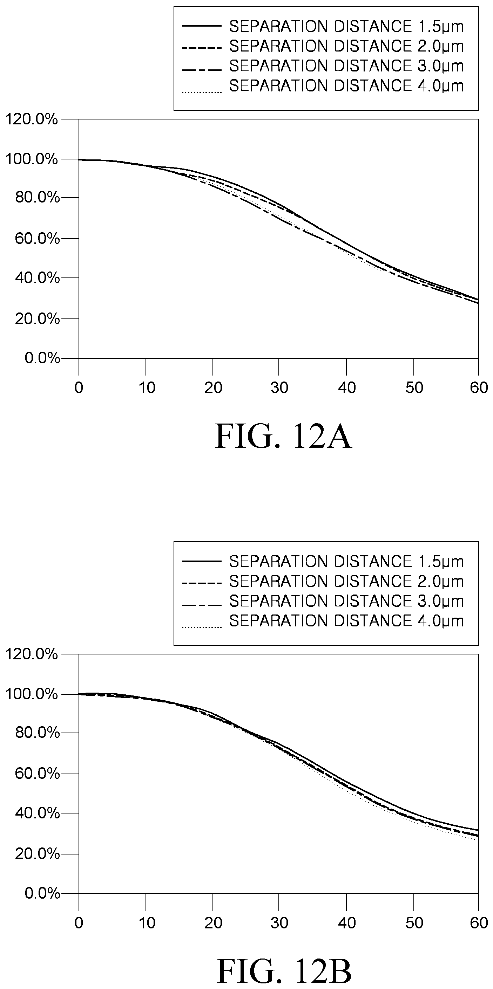

FIG. 12A and FIG. 12B are graphs showing a viewing angle-dependent luminance of a blue sub-pixel.

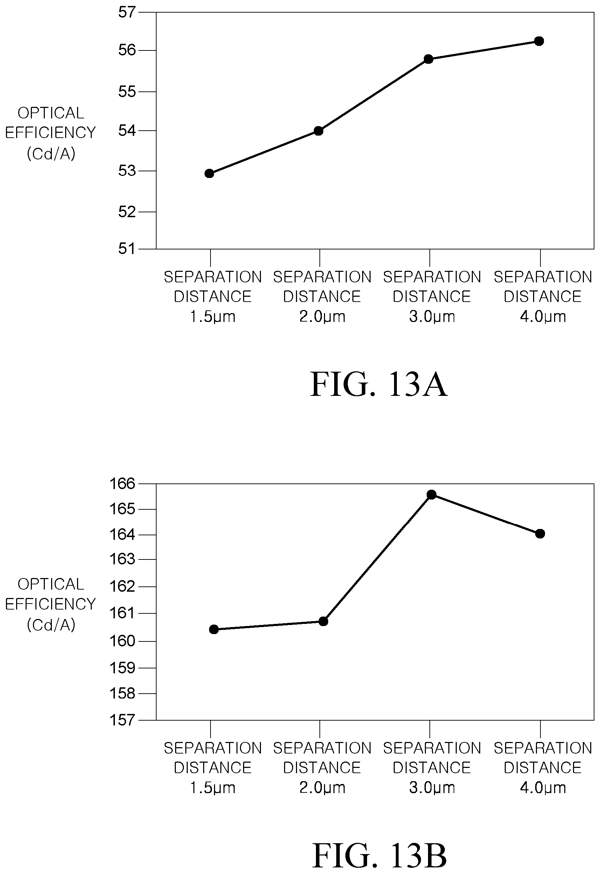

FIG. 13A through FIG. 13C are graphs showing an optical efficiency depending on a separation distance.

Herein, the separation distance can refer to a distance between an anode having an SM structure and a main emission area or a distance between a side portion of the anode and a side portion of a bank.

FIG. 10A is a graph showing a viewing angle-dependent luminance of a red sub-pixel when the pixel of FIG. 4 is viewed from the right (Φ = 0). Herein, an X-axis shows changes in viewing angle from the front (θ = 0) to the right (θ = 60), and a Y-axis shows luminance values depending on a normalized viewing angle based on a front side luminance.

FIG. 10B is a graph showing a viewing angle-dependent luminance of a red sub-pixel when the pixel of FIG. 4 is viewed from below (Φ = 90). Herein, an X-axis shows changes in viewing angle from the front (θ = 0) to below (θ = 60), and a Y-axis shows luminance values depending on a normalized viewing angle based on a front side luminance.

FIG. 11A is a graph showing a viewing angle-dependent luminance of a green sub-pixel when the pixel of FIG. 4 is viewed from the right (Φ = 0). Herein, an X-axis shows changes in viewing angle from the front (θ = 0) to the right (θ = 60), and a Y-axis shows luminance values depending on a normalized viewing angle based on a front side luminance.

FIG. 11B is a graph showing a viewing angle-dependent luminance of a green sub-pixel when the pixel of FIG. 4 is viewed from below (Φ = 90). Herein, an X-axis shows changes in viewing angle from the front (θ = 0) to below (θ = 60), and a Y-axis shows luminance values depending on a normalized viewing angle based on a front side luminance.

FIG. 12A is a graph showing a viewing angle-dependent luminance of a blue sub-pixel when the pixel of FIG. 4 is viewed from the right (Φ = 0). Herein, an X-axis shows changes in viewing angle from the front (θ = 0) to the right (θ = 60), and a Y-axis shows luminance values depending on a normalized viewing angle based on a front side luminance.

FIG. 12B is a graph showing a viewing angle-dependent luminance of a blue sub-pixel when the pixel of FIG. 4 is viewed from below (Φ = 90). Herein, an X-axis shows changes in viewing angle from the front (θ = 0) to below (θ = 60), and a Y-axis shows luminance values depending on a normalized viewing angle based on a front side luminance.

Each of FIG. 10A, FIG. 10B, FIG. 11A, FIG. 11B, FIG. 12A, and FIG. 12B shows a viewing angle-dependent luminance of each of a red sub-pixel, a green sub-pixel, and a blue sub-pixel depending on separation distances of 1.5 µm, 2.0 µm, 3.0 µm, and 4.0 µm.

FIG. 13A is a graph showing an optical efficiency (Cd/A) of a red sub-pixel depending on separation distances of 1.5 µm, 2.0 µm, 3.0 µm, and 4.0 µm.

FIG. 13B is a graph showing an optical efficiency (Cd/A) of a green sub-pixel depending on separation distances of 1.5 µm, 2.0 µm, 3.0 µm, and 4.0 µm.

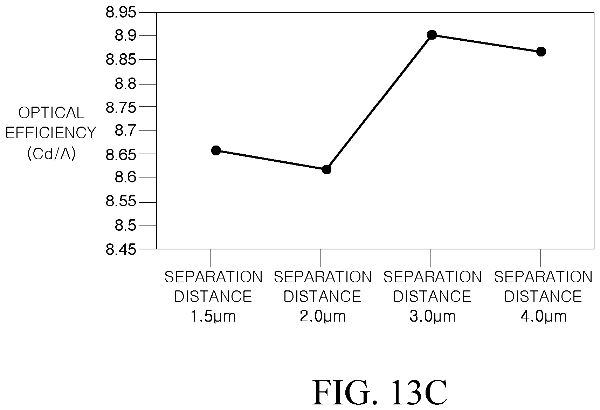

FIG. 13C is a graph showing an optical efficiency (Cd/A) of a blue sub-pixel depending on separation distances of 1.5 µm, 2.0 µm, 3.0 µm, and 4.0 µm.

Referring to FIG. 10A, FIG. 10B, FIG. 11A, FIG. 11B, FIG. 12A, FIG. 12B, and FIG. 13A through FIG. 13C, the luminance viewing angle is improved as the separation distance is decreased. Further, the optical efficiency is improved as the separation distance is increased.

Specifically, it can be seen that the luminance viewing angle is the highest in each of the red sub-pixel, the green sub-pixel, and the blue sub-pixel when the separation distance is 1.5 µm. Further, it can be seen that the luminance viewing angle is improved as the separation distance is decreased from 4.0 µm to 3.0 µm, 2.0 µm and 1.5 µm. Particularly, it can be seen that at Φ = 0 in the red sub-pixel, the luminance viewing angle is remarkably improved as the separation distance is decreased. Further, it can be seen that at Φ = 90 in the green sub-pixel, the luminance viewing angle is generally improved. Further, it can be seen that in the red sub-pixel, the luminance viewing angle is remarkably improved as the separation distance is decreased.

It can be seen that the optical efficiency is the highest in the red sub-pixel when the separation distance is 4.0 µm, and the optical efficiency is improved as the separation distance is increased from 1.5 µm to 2.0 µm, 3.0 µm and 4.0 µm. It can be seen that in the green sub-pixel, the optical efficiency is the highest when the separation distance is 3.0 µm, and the optical efficiency is improved as the separation distance is increased from 1.5 µm to 2.0 µm and 3.0 µm. Further, it can be seen that in the blue sub-pixel, the optical efficiency is the highest when the separation distance is 3.0 µm, and the optical efficiency is generally improved as the separation distance is increased from 1.5 µm to 2.0 µm and 3.0 µm.

Therefore, the separation distance can be shortened to improve the luminance viewing angle, and can be increased to improve the optical efficiency. Further, it is possible to improve any desired characteristics of the luminance viewing angle and the optical efficiency of each sub-pixel. Further, it is possible to improve any desired characteristics of the luminance viewing angle and the optical efficiency at each location. Furthermore, it can be seen that the luminance viewing angle in a main viewing angle direction (major axis direction) of the sub-pixel having a rectangular shape is affected by the anode having an SM structure parallel to the major axis direction. Thus, it can be seen that when the separation distance is regulated, the order of improving the luminance viewing angle and the optical efficiency can be determined. Further, it can be seen that the SM structure parallel to the main viewing angle direction (major axis direction) is effective in increasing the luminance viewing angle in that direction. With the design employing these two factors, it is possible to improve the luminance viewing angle and the optical efficiency simultaneously. Further, it is possible to further improve the luminance viewing angle in the main viewing angle direction.

Meanwhile, the sub-pixel (or the main emission area, the second opening, or the side portion of the bank) of the present disclosure can have an approximately (or overall) rectangular shape as well as various shapes, such as a circular shape or an oval shape. This will be described in detail with reference to the accompanying drawings.

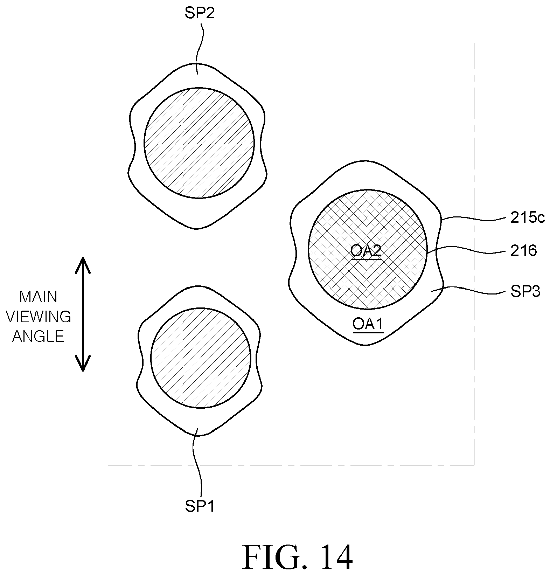

FIG. 14 illustrates a pixel structure in a display panel according to a second embodiment of the present disclosure.

The display panel according to the second embodiment of the present disclosure shown in FIG. 14 is substantially the same as that of the first embodiment shown in FIG. 1 through FIG. 9A and FIG. 9B described above only except a pixel structure. Therefore, redundant description of the same components will be omitted. Hereinafter, description of the same reference numerals can refer to FIG. 1 through FIG. 9A and FIG. 9B.

FIG. 14 illustrates a part of a display panel in which three sub-pixels SP1, SP2 and SP3 are disposed. Further, FIG. 14 illustrates a bank 216 including the second opening OA2 as a main emission area and a third planarization layer 215c on which an anode having an SM structure is disposed.

FIG. 14 illustrates a pixel structure in a display panel whose main viewing angle direction is the upward and downward direction.

Referring to FIG. 14, a first sub-pixel SP1, a second sub-pixel SP2, and a third sub-pixel SP3 can be disposed in a pixel area.

For example, the first sub-pixel SP1 can be a red sub-pixel.

For example, the second sub-pixel SP2 can be a green sub-pixel.

For example, the third sub-pixel SP3 can be a blue sub-pixel.

For example, each of the first sub-pixel SP1, the second sub-pixel SP2, and the third sub-pixel SP3 can have a circular shape, but is not limited thereto.

Herein, the shape of the sub-pixels SP1, SP2 and SP3 can be defined by the shape of the second opening OA2. However, the present disclosure is not limited thereto.

In the same manner as in the first embodiment, the third planarization layer 215c on which the anode having an SM structure is disposed can include the first opening OA1 provided by removing (opening) a portion corresponding to the main emission area, the reflective emission area, and the first non-emission area of the sub-pixels SP1, SP2 and SP3.

Further, in the second embodiment of the present disclosure, a side portion of the third planarization layer 215c in contact with a side surface of the anode having an SM structure has a shape that differs between its left and right sides and its upper and lower sides when viewed from the top. Thus, it is possible to improve the luminance viewing angle and the optical efficiency in a specific direction. For example, a distance between a side portion of the anode and a side portion of the bank 216 is shortened in a direction parallel to the main viewing angle direction of the sub-pixels SP1, SP2 and SP3. Thus, it is possible to maximize the improvement of the luminance viewing angle. Further, a distance between the side portion of the anode and the side portion of the bank 116 is increased in a direction perpendicular to the main viewing angle direction. Thus, it is possible to maximize the improvement of the optical efficiency. In this case, for example, a left and right width of the first opening OA1 is the smallest at the center and gradually increases in the upward and downward direction when viewed from the top. Further, an upper and lower width of the first opening OA1 is the greatest at the center and gradually decreases in the left and right direction when viewed from the top. Therefore, the left and right sides of the first opening OA1 can have an inwardly concave shape, whereas the upper and lower sides of the first opening OA1 can have an outwardly convex shape. Accordingly, an edge of the first opening OA1 can have an approximately hexagonal shape whose left and right sides have an inwardly concave shape.

As described above, according to the present disclosure, the distance between the side portion of the anode and the side portion of the bank 216 varies depending on the viewing angle direction within each of the sub-pixels SP1, SP2 and SP3. The amount of light extraction increased by the SM structure can be controlled by an increase in luminance viewing angle and/or optical efficiency depending on the viewing angle direction. For example, the luminance viewing angle can be improved by concentrating the amount of light extraction in the main viewing angle direction. Therefore, the distance between the side portion of the anode having an SM structure and the side portion of the bank 216 can be regulated to provide a directionality.

Meanwhile, the sub-pixels of the present disclosure can have different shapes or sizes. Therefore, the anode, the first openings and/or the second opening can have different shapes or sizes. This will be described in detail with reference to the accompanying drawings.

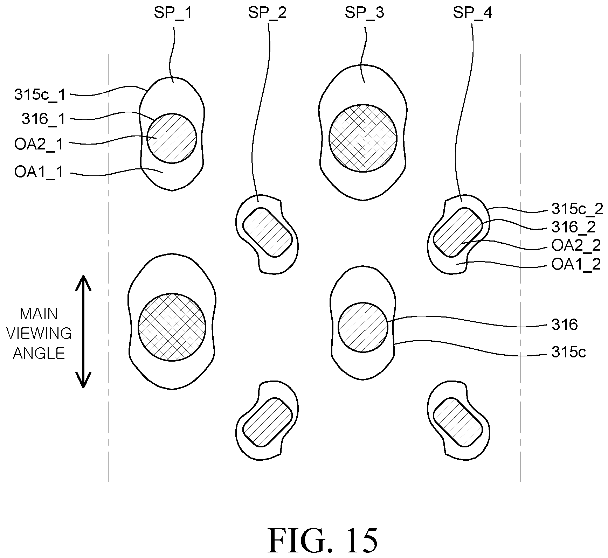

FIG. 15 illustrates a pixel structure in a display panel according to a third embodiment of the present disclosure.

The third embodiment shown in FIG. 15 is substantially the same as the above-described embodiments only except that sub-pixels SP1, SP2, SP3 and SP4 have different shapes or sizes. Therefore, redundant description of the same components will be omitted. Hereinafter, description of the same reference numerals can refer to FIG. 1 through FIG. 14.

FIG. 15 illustrates a part of a display panel in which four sub-pixels SP_1, SP_2, SP_3 and SP_4 are disposed. Further, FIG. 15 illustrates banks 316_1 and 316_2 including second openings OA2_1 and OA2_2, respectively, and third planarization layers 315c_1 and 315c_2 including first openings OA1_1 and OA1_2, respectively.

In FIG. 15, for the convenience of description, only some of the components of a first type sub-pixel SP_1 and a second type sub-pixel SP_2 will be described by referring to reference numerals.

FIG. 15 illustrates a pixel structure in a display panel whose main viewing angle direction is the upward and downward direction.

Referring to FIG. 15, the display panel according to the third embodiment of the present disclosure can include a pixel area in which a plurality of sub-pixels SP_1, SP_2, SP_3 and SP_4 is disposed, and a line area in which various signal lines are disposed.

For example, in the pixel area, a plurality of first type sub-pixels SP_1, second type sub-pixels SP_2, third type sub-pixels SP_3 and fourth type sub-pixels SP_4 can be disposed.

The plurality of first type sub-pixels SP_1, second type sub-pixels SP_2, third type sub-pixels SP_3 and fourth type sub-pixels SP_4 can have different shapes or sizes, but can have substantially the same configuration.

For example, the first type sub-pixels SP_1 can be red, green, or blue sub-pixels.

For example, the second type sub-pixels SP_2 can be red, green, or blue sub-pixels.

For example, the third type sub-pixels SP_3 can be red, green, or blue sub-pixels.

For example, the fourth type sub-pixels SP_4 can be red, green, or blue sub-pixels.

For example, the first type sub-pixels SP_1 and the third type sub-pixels SP_3 can have an approximately circular shape, but the present disclosure is not limited thereto. Further, the first type sub-pixels SP_1 can have a smaller size than the third type sub-pixels SP_3.

For example, the second type sub-pixels SP_2 and the fourth type sub-pixels SP_4 can have an approximately oval shape or rectangular shape, but the present disclosure is not limited thereto. Further, the second type sub-pixels SP_2 can be horizontally symmetrical with respect to the fourth type sub-pixels SP_4, but the present disclosure is not limited thereto.

Herein, the shape of the sub-pixels SP_1, SP_2, SP_3 and SP_4 can be defined by the shape of the second openings OA2_1 and OA2_2. However, the present disclosure is not limited thereto.

Meanwhile, according to the present disclosure, the anode has an SM structure. Therefore, the reflective emission area is added in addition to the main emission area. Thus, each emission area can be expanded as compared to each of the sub-pixels SP_1, SP_2, SP_3 and SP_4.

Further, according to the third embodiment of the present disclosure, the first type sub-pixel SP_1 and the third type sub-pixel SP_3 can include a first type bank 316_1. Further, the second type sub-pixel SP_2 and the fourth type sub-pixel SP_4 can include a second type bank 316_2. Further, the first type sub-pixel SP_1 and the third type sub-pixel SP_3 can include a first type anode. The second type sub-pixel SP_2 and the fourth type sub-pixel SP_4 can include a second type anode. Furthermore, the first type sub-pixel SP_1 and the third type sub-pixel SP_3 can include a first type third planarization layer 315c_1. The second type sub-pixel SP_2 and the fourth type sub-pixel SP_4 can include a second type third planarization layer 315c_2.

For example, the third planarization layers 315c_1 and 315c_2 can include the first openings OA1_1 and OA1_2, respectively, provided by removing (opening) a portion corresponding to the main emission area, the reflective emission area, and the non-emission area of the sub-pixel. The first openings OA1_1 and OA1_2 can include a first type first opening OA1_1 of the first type sub-pixel SP_1 and the third type sub-pixel SP_3 and a second type first opening OA1_2 of the second type sub-pixel SP_2 of the fourth type sub-pixel SP_4.

When viewed from the top, the first type first opening OA1_1 can have an approximately oval shape whose left and right width is the smallest at the center and gradually increases in the upward and downward direction and whose upper and lower width is the greatest at the center and gradually decreases in the left and right direction. Therefore, the left and right sides of the first type first opening OA1_1 can have an inwardly concave shape, whereas the upper and lower sides of the first type first opening OA1_1 can have an outwardly convex shape.

Further, when viewed from the top, the second type first opening OA1_2 can have an approximately oval shape whose left and right width is the smallest at the center and gradually increases in the upward and downward direction and whose upper and lower width is the greatest at the center and gradually decreases in the left and right direction. Therefore, the left and right sides of the second type first opening OA1_2 can have an inwardly concave shape based on the inclined oval shape, whereas the upper and lower sides of the second type first opening OA1_2 can have an outwardly convex shape based on the inclined oval shape.

Further, for example, the banks 316_1 and 316_2 can include the second openings OA2_1 and OA2_2 provided by removing (opening) a portion corresponding to the main emission area of each of the sub-pixels SP_1, SP_2, SP_3 and SP_4. For example, the first openings OA1_1 and OA1_2 can have a greater width than the second openings OA2_1 and OA2_2. The second openings OA2_1 and OA2_2 can include a first type second opening OA2_1 of the first type sub-pixel SP_1 and the third type sub-pixel SP_3 and a second type second opening OA2_2 of the second type sub-pixel SP_2 and the fourth type sub-pixel SP_4.

When viewed from the top, the first type second opening OA2_1 can have an approximately circular shape. Further, for example, the first type second opening OA2_1 of the first type sub-pixel SP_1 can have a smaller size than the first type second opening OA2_1 of the third type sub-pixel SP_3. However, the present disclosure is not limited thereto.

Further, when viewed from the top, the second type second opening OA2_2 can have an approximately inclined rectangular shape. Further, for example, the second type second opening OA2_2 of the second type sub-pixel SP_2 can be horizontally symmetrical with respect to the second type second opening OA2_2 of the fourth type sub-pixel SP_4. However, the present disclosure is not limited thereto.

Meanwhile, according to the present disclosure, the anode has an SM structure. When a Color On Encapsulation (COE) structure in which a color filter layer is disposed on an encapsulation unit is applied to the present disclosure, the luminance viewing angle is increased in the main viewing angle direction. Therefore, a width of a black matrix in the main viewing angle direction can be reduced, and, thus, an aperture ratio can be improved. This will be described in more detail with reference to the accompanying drawings.

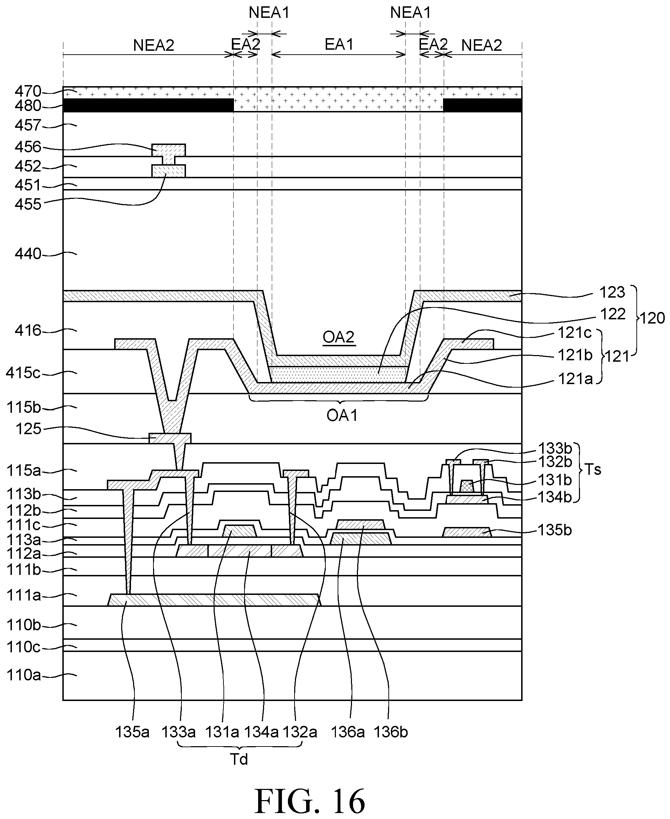

FIG. 16 is a partial cross-sectional view of a sub-pixel in a display panel according to a fourth embodiment of the present disclosure.

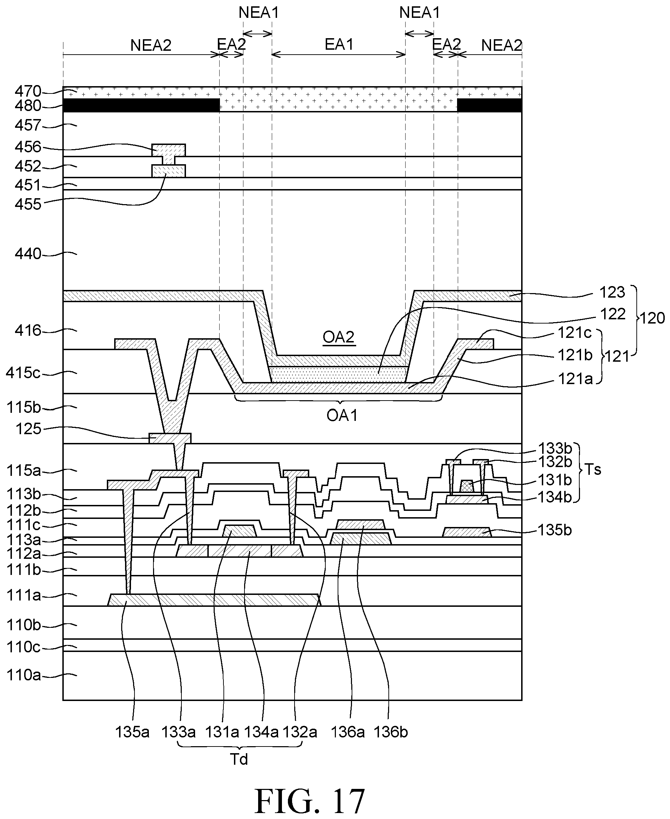

FIG. 17 is another partial cross-sectional view of the sub-pixel in the display panel according to the fourth embodiment of the present disclosure.

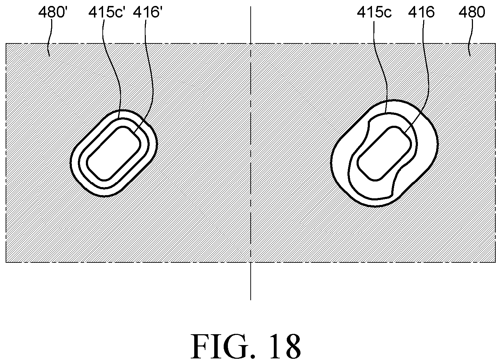

FIG. 18 is a plan view illustrating a part of a sub-pixel structure in a Color On Encapsulation (COE) structure.

FIG. 16 illustrates a part of a cross-section of the center of the second sub-pixel SP2 of FIG. 4 as taken along the left and right direction. Further, FIG. 17 illustrates a part of a cross-section of the center of the second sub-pixel SP2 of FIG. 4 as taken along the upward and downward direction.

FIG. 18 illustrates a planar structure of black matrixes 480' and 480 in a sub-pixel to which the COE structure is applied. The left side of FIG. 18 shows a planar structure of a sub-pixel according to a comparative embodiment, and the right side of FIG. 18 shows a planar structure of a sub-pixel according to the fourth embodiment of the present disclosure. FIG. 18 illustrates an example where the sub-pixel has an oval shape. However, the present disclosure is not limited thereto.

The display panel according to the fourth embodiment shown in FIG. 16 through FIG. 18 is substantially the same as that of the first embodiment shown in FIG. 1 through FIG. 9A and FIG. 9B only except that a color filter layer 470 and a black matrix 480 are disposed on an encapsulation unit 440. Therefore, redundant description of the same components will be omitted. Hereinafter, description of the same reference numerals can refer to FIG. 1 through FIG. 9A and FIG. 9B.

Referring to FIG. 16 through FIG. 18, the driving transistor Td, the switching transistor Ts, and the light emitting element 120 can be disposed on the substrate 110 (e.g. on the substrates 110a, 110b and 110c). This will be described in detail with reference to the above-described embodiments.

Further, according to the fourth embodiment of the present disclosure in the same manner as in the above-described embodiments, for example, a third planarization layer 415c can include the first opening OA1 provided by removing (opening) a portion corresponding to the main emission area EA1, the reflective emission area EA2, and the first non-emission area NEA1 of the sub-pixels. A bank 416 including a second opening OA2 can be on the third planarization layer 415c.

When viewed from the top, the first opening OA1 can have an approximately (or overall) circular shape, oval shape or rectangular shape whose left and right width is the smallest at the center and gradually increases in the upward and downward direction and whose upper and lower width is the greatest at the center and gradually decreases in the left and right direction (see FIG. 7, FIG. 8, and FIG. 18 described above). Therefore, the left and right sides of the first opening OA1 can have an inwardly concave shape, whereas the upper and lower sides of the first opening OA1 can have an outwardly convex shape (see FIG. 9A, FIG. 9B, and FIG. 18 described above).

The third planarization layer 415c can include a top surface and a side portion.

The side portion of the third planarization layer 415c can have an approximately (or overall) circular shape, oval shape or rectangular shape whose left and right width is the smallest at the center and gradually increases in the upward and downward direction and whose upper and lower width is the greatest at the center and gradually decreases in the left and right direction (see FIG. 7, FIG. 8, and FIG. 18 described above) when viewed from the top in the same manner as the edge of the first opening OA1. Therefore, the left and right sides of the side portion of the third planarization layer 415c can have an inwardly concave shape, whereas the upper and lower sides of the side portion of the third planarization layer 415c can have an outwardly convex shape (see FIG. 9A and FIG. 9B described above).

Further, for example, the anode 121 can be disposed on a part of the top surface and the side portion of the third planarization layer 415c and a part of the top surface of the second planarization layer 115b.

Further, according to the fourth embodiment of the present disclosure, the left and right sides of the side portion of the third planarization layer 415c have an inwardly concave shape and the upper and lower sides thereof have an outwardly convex shape. Thus, the left and right sides of the second area 121b of the anode 121 deposited thereon can also have an inwardly concave shape and the upper and lower sides thereof can have an outwardly convex shape. Therefore, the reflective emission area EA2 can have an approximately (or overall) circular shape, oval shape or polygonal annular shape, such as a rectangular annular shape, whose left and right sides have an inwardly concave shape and upper and lower sides have an outwardly convex shape when viewed from the top. But is not limited thereto. In this case, for example, the reflective emission area EA2 follows an outline of the main emission area EA1. Further, when the light emitting element 120 emits light, the reflective emission area EA2 is shown as a continuous rectangular annular emission image or a discontinuous rectangular annular emission image. The annular shape of the reflective emission area EA2 can have the smallest width at a corner of the main emission area EA1, and the first non-emission area NEA1 can have the greatest width at the corner of the main emission area EA1. However, the present disclosure is not limited thereto. When the first opening OA1 has a polygonal shape, the reflective emission area EA2 can be shown as a polygonal annular emission image corresponding in shape to the first opening OA1. When the reflective emission area EA2 is shown as a discontinuous rectangular annular emission image, it can have a discontinuous shape in the middle surrounding the outline of the main emission area EA1. For example, the annular shape of the reflective emission area EA2 can decrease in width or can be discontinuous as it gets closer to the corner of the main emission area EA1. A portion where the annular shape of the reflective emission area EA2 decreases in width or is discontinuous can have a greater width of the first non-emission area NEA1 than the other portion. This portion can show a lower luminance than a portion where the main emission area EA1 or the reflective emission area EA2 is continuous as the amount of light emitted from the light emitting element 120 and reflected from the SM structure decreases.

According to the fourth embodiment of the present disclosure in the same manner as the above-described embodiments, a distance (separation distance) between the second area 121b of the anode 121 having an SM structure and the main emission area EA1 varies within a sub-pixel. For example, the separation distance at the center in the left and right direction of the sub-pixel can be smaller than the separation distance at the center in the upward and downward direction. Further, for example, the separation distance is the smallest at the center in the left and right direction of the sub-pixel and gradually increases in the upward and downward direction. For example, the separation distance is the greatest at the center in the upward and downward direction of the sub-pixel and gradually decreases in the left and right direction.

As described above, the SM structure provided in the first opening OA1 forms the reflective emission area EA2. It can be seen that a width of the reflective emission area EA2 increases at the center in the upward and downward direction of the sub-pixel (where the separation distance is relatively long) (see FIG. 17 and FIG. 18).

Further, for example, the left and right sides of the edge of the reflective emission area EA2 can have an inwardly concave shape corresponding in shape to the side portion of the third planarization layer 415c and the second area 121b of the anode 121. Further, the upper and lower sides of the edge of the reflective emission area EA2 can have an outwardly convex shape. Therefore, it is possible to improve the luminance viewing angle and the optical efficiency. Further, it is possible to further improve the luminance viewing angle in the main viewing angle direction.

Meanwhile, the encapsulation unit 440 can be disposed on the light emitting element 120.

The light emitting element 120 can react with external moisture or oxygen due to properties of an organic material of the organic layer 122, which can cause the occurrence of dark spots or pixel shrinkage. In order to suppress the occurrence of dark spots or pixel shrinkage, the encapsulation unit 440 can be disposed on the cathode 123. The encapsulation unit 440 can be composed of a first inorganic insulating film, a foreign material compensation layer, and a second inorganic insulating film, but is not limited thereto.

The first inorganic insulating film can be disposed on the substrate 110 (the substrates 110a, 110b and 110c) on which the cathode 123 has been disposed so as to be closest to the light emitting element 120.

For example, the first inorganic insulating film can be made of an inorganic insulating material, such as silicon nitride (SiNx), silicon oxide (SiOx), silicon oxide nitride (SiON), or aluminum oxide (Al₂O₃), which can be subjected to low temperature deposition, but is not limited thereto. Since the first inorganic insulating film is deposited under a low-temperature atmosphere, it is possible to suppress damage to the organic layer 122, which contains an organic material vulnerable to a high-temperature atmosphere, during the deposition.

The foreign material compensation layer can be disposed in a smaller area than the first inorganic insulating film. Therefore, the foreign material compensation layer can be disposed to expose both ends of the first inorganic insulating film. The foreign material compensation layer can be made of an organic insulating material, such as acrylic resin, epoxy resin, polyimide, polyethylene, or silicon oxy carbon (SiOC) , but is not limited thereto.

Meanwhile, when the foreign material compensation layer is formed by an inkjet method, one or more dams can be disposed at a boundary between a non-active area and an active area or in a dam area corresponding to a part of the non-active area. In this dam area, a primary dam adjacent to the active area and a secondary dam adjacent to a pad can be disposed.

When a liquid type foreign material compensation layer is dropped in the active area, the one or more dams disposed in the dam area can suppress collapse of the liquid type foreign material compensation layer toward the non-active area and invasion of the liquid type foreign material compensation layer into the pad.

The primary dam and/or secondary dam can have a single layer structure or a multi-layer structure.

Further, the foreign material compensation layer containing an organic material can be located only on an inner surface of the primary dam.

Furthermore, the second inorganic insulating film can be disposed to cover a top surface and a side surface of each of the first inorganic insulating film and the foreign material compensation layer. The second inorganic insulating film can serve to minimize or block the permeation of external moisture or oxygen into the first inorganic insulating film and the foreign material compensation layer. The second inorganic insulating film can be made of an inorganic insulating material, such as silicon nitride (SiNx), silicon oxide (SiOx), silicon oxynitride (SiON), or aluminum oxide (Al₂O₃), but is not limited thereto.

A touch buffer film 451 can be disposed on the encapsulation unit 440.

A bridge pattern 455 can be disposed on the touch buffer film 451, but is not limited thereto. A touch electrode (or touch line) can be disposed on the touch buffer film 451.

The touch buffer film 451 can be located between the bridge pattern 455 and the encapsulation unit 440.

The bridge pattern 455 can be disposed on the encapsulation unit 440 without the touch buffer film 451.

The bridge pattern 455 can have a single layer structure or a multi-layer structure made of a metal having strong corrosion resistance and acid resistance, such as aluminum (Al), titanium (Ti), copper (Cu), or molybdenum (Mo), but is not limited thereto.

A touch insulating film 452 can be disposed on the bridge pattern 455.

For example, the touch insulating film 452 can use an organic film or an inorganic film which can be formed by a low temperature process. When the organic film is used for the touch insulating film 452, the touch insulating film 452 can be formed by coating the organic film on the substrate 110 (the substrates 110a, 110b and 110c) and then curing the organic film at a temperature of 100°C or less to suppress damage to the organic layer 122 vulnerable to high temperatures. When the inorganic film is used for the touch insulating film 452, the touch insulating film 452 having a multi-layer structure can be formed by repeating a low temperature CVD deposition process and a cleaning process at least two times to suppress damage to the organic layer 122 vulnerable to high temperatures.

A portion of the touch insulating film 452 is selectively removed, and, thus, a touch connection hole can be formed to expose a part of the bridge pattern 455.

A touch electrode (or touch line) 456 can be disposed on the touch insulating film 452, but is not limited thereto. A bridge pattern can be disposed on the touch insulating film 452.

For example, the touch electrode 456 can be electrically connected to the bridge pattern 455 through the touch connection hole.

Further, a touch planarization layer 457 can be disposed on the touch electrode 456, but is not limited thereto. The touch planarization layer can be omitted in some embodiments.

The black matrix 480 can be disposed on the touch planarization layer 457.

The black matrix 480 can be located above the touch electrode 456.

The black matrix 480 can be located corresponding to a second non-emission area NEA2.

The color filter layer 470 can be disposed in the second non-emission area NEA2 of the black matrix 480, the main emission area EA1, the reflective emission area EA2, and the first non-emission area NEA1.

For example, the color filter layer 470 can include a red color filter layer, a green color filter layer, and a blue color filter layer, but is not limited thereto. The color filter layer 470 can further include a white color filter layer.

The black matrix 480 can be disposed at a boundary between the color filter layers 470 for different colors. Thus, the black matrix 480 can define a sub-pixel area. The sub-pixel area defined by the black matrix 480 can include a red sub-pixel area, a green sub-pixel area, and a blue sub-pixel area. Further, the sub-pixel area can further include a white sub-pixel area. For example, a portion where the red color filter layer is disposed can correspond to the red sub-pixel area, and a portion where the green color filter layer is disposed can correspond to the green sub-pixel area. Further, a portion where the blue color filter layer is disposed can correspond to the blue sub-pixel area, and a portion where the white color filter layer is disposed can correspond to the white sub-pixel area.

For example, red light can be emitted from the portion where the red color filter layer is disposed, and green light can be emitted from the portion where the green color filter layer is disposed. Further, blue light can be emitted from the portion where the blue color filter layer is disposed, and white light can be emitted from the portion where the white color filter layer is disposed.

Meanwhile, as described above, the anode 122 of the present disclosure has an SM structure. Thus, it is possible to increase the amount of light extraction. For example, the second area 122b of the anode 122 including a reflective layer serves as a side mirror. The side mirror reflects and extracts light, which is generated from the light emitting element 120 and emitted toward the second area 122b, in a forward direction. Thus, it is possible to improve the efficiency of the display device. Further, the color filter layer 470 and the black matrix 480 are disposed on the encapsulation unit 440, and, thus, a polarizer can be removed. Therefore, it is possible to improve the optical efficiency.

Further, when the COE structure is applied to the SM structure, the luminance viewing angle is improved in the main viewing angle direction. Thus, it is possible to reduce the size of the black matrix 480 in the main viewing angle direction. For example, referring to FIG. 18, a side portion of a third planarization layer 415c' can have an inclined oval shape in the SM structure of the comparative embodiment when viewed from the top as shown on the left side of FIG. 18. In this case, the black matrix 480 can be opened in an inclined oval shape in the same manner as the reflective emission area along the circumference of the reflective emission area. Meanwhile, the left and right sides of a side portion of the third planarization layer 415c in the SM structure combined with the COE structure of the fourth embodiment of the present disclosure as shown on the right side of FIG. 18 have an inwardly concave shape and the upper and lower sides thereof have an outwardly convex shape as compared to the inclined oval shape of the comparative embodiment. Therefore, the size of the black matrix 480 can be reduced in the main viewing angle direction. Thus, it is possible to improve an aperture ratio. In FIG. 18, banks 416' and 416 are shown.

Meanwhile, according to the present disclosure, when a color viewing angle decreases only in a specific direction, color viewing angle characteristics can be improved by changing the design of the SM structure of a sub-pixel of a specific color. This will be described in detail with reference to the accompanying drawings.

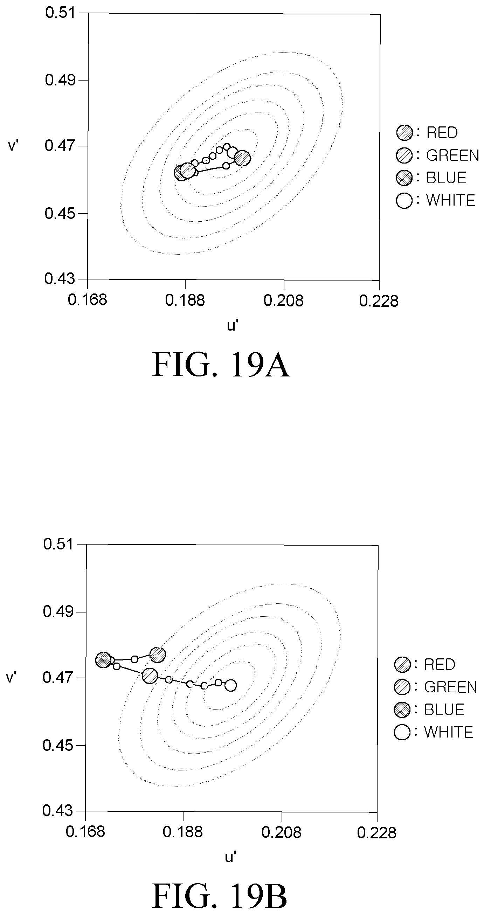

FIG. 19A is a graph showing a color coordinate shift amount of white light depending on a viewing angle in an upward direction from the center of a display panel according to the comparative embodiment.

FIG. 19B is a graph showing a color coordinate shift amount of white light depending on a viewing angle in a downward direction from the center of the display panel according to the comparative embodiment.

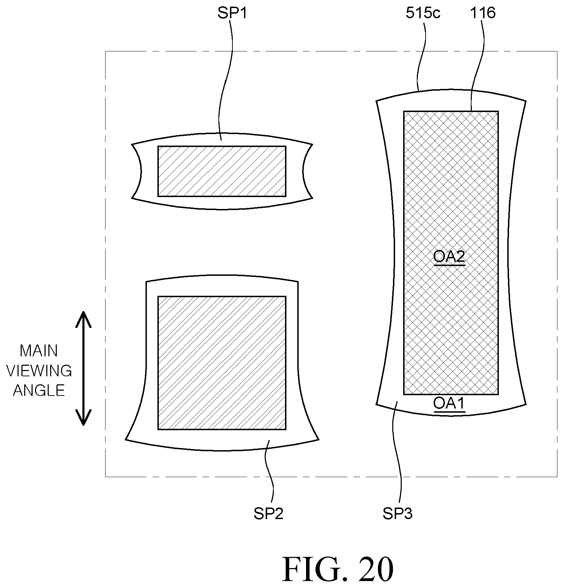

FIG. 20 illustrates a pixel structure in a display panel according to a fifth embodiment of the present disclosure.

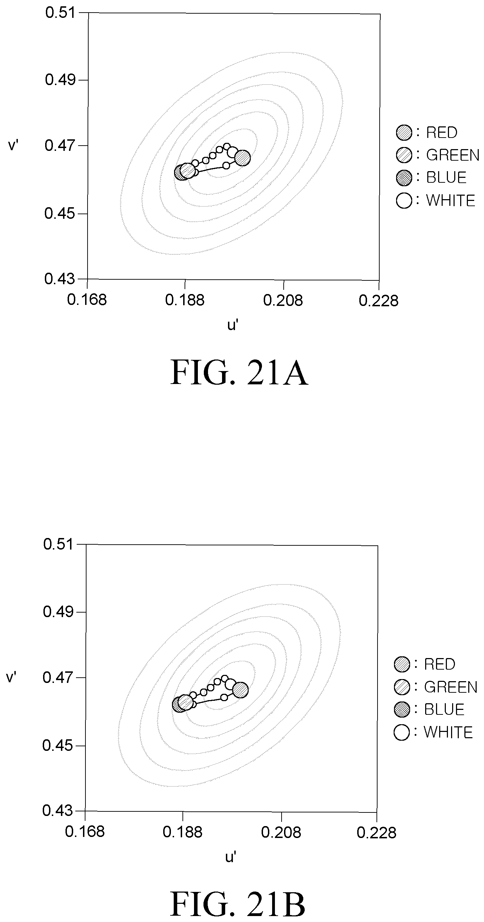

FIG. 21A is a graph showing a color coordinate shift amount of white light depending on a viewing angle in an upward direction from the center of a display panel according to an embodiment.

FIG. 21B is a graph showing a color coordinate shift amount of white light depending on a viewing angle in a downward direction from the center of the display panel according to the embodiment.

The graphs of FIG. 19A and FIG. 19B according to the comparative embodiment show the results of measuring color coordinates of white light by forming viewing angles in an upward direction (azimuth angle of 270°) and a downward direction (azimuth angle of 90°) in a state where the front is viewed at the center of the display panel with the sub-pixel structure of FIG. 4.

The graphs of FIG. 21A and FIG. 21B according to the embodiment show the results of measuring color coordinates of white light by forming viewing angles in an upward direction (azimuth angle of 270°) and a downward direction (azimuth angle of 90°) in a state where the front is viewed at the center of the display panel with the sub-pixel structure of FIG. 20.

In this case, the right direction, the upward direction, the left direction, and the downward direction of the display panel can be represented by azimuth angles of 0°, 90°, 180°, and 270°, respectively.

Further, the color coordinate shift amount Δu'v' refers to a difference between the color coordinates as seen at the front and the color coordinates at a viewing angle, and the color coordinates u'v' refer to 1976 UCS color space defined in International Commission on Illumination CIE 15.2.

FIG. 19A and FIG. 19B show the comparative embodiment where the color coordinate shift amount Δu'v' depending on a viewing angle shifts to green in the upward direction of the display panel, whereas the color coordinate shift amount Δu'v' depending on a viewing angle does not greatly change in the downward direction of the display panel.

In this case, the color coordinates lay in the greenish field in a specific direction, e.g., in the upward direction of the display panel, and the color viewing angle can decrease.

To respond to this decrease, the design of the SM structure of a sub-pixel of a specific color, e.g., the green sub-pixel SP2 of FIG. 20, can be changed according to the fifth embodiment of the present disclosure. For example, a third planarization layer 515c in the SM structure in the green sub-pixel SP2 can be changed in shape. For example, a left and right width of the side portion of the third planarization layer 515c is the smallest at the center and gradually increases in the downward direction but is kept almost constant in the upward direction when viewed from the top. Further, an upper and lower width of the side portion of the third planarization layer 515c is the greatest at the center and gradually decreases in the left and right direction when viewed from the top.

It can be seen from FIG. 21A and FIG. 21B that in the pixel structure of FIG. 20 in which the design of the SM structure of the green sub-pixel SP2 is changed, the color coordinate shift amount Δu'v' depending on a viewing angle does not greatly change in the upward and downward direction of the display panel. Therefore, when the color viewing angle decreases only in a specific direction, color viewing angle characteristics can be improved by changing the design of the SM structure of a sub-pixel of a specific color. For example, it is possible to suppress a color shift depending on a viewing angle and thus possible to provide sharper image quality.

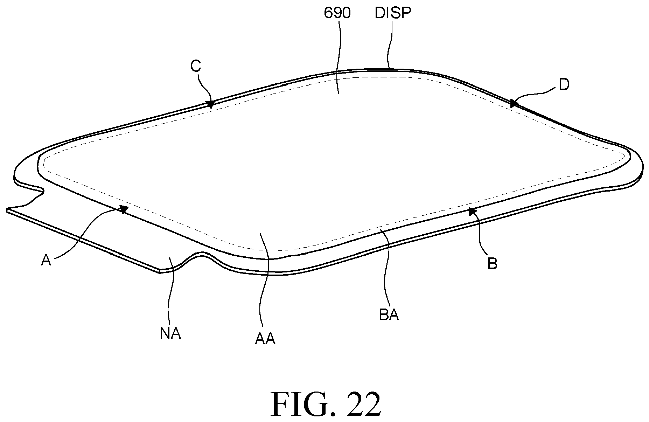

FIG. 22 is a perspective view illustrating a display device according to a sixth embodiment of the present disclosure.

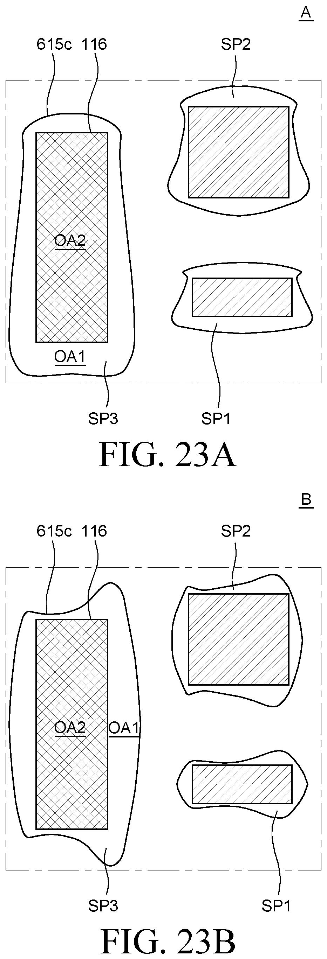

FIG. 23A illustrates a pixel structure in the part A of FIG. 22.

FIG. 23B illustrates a pixel structure in the part B of FIG. 22.

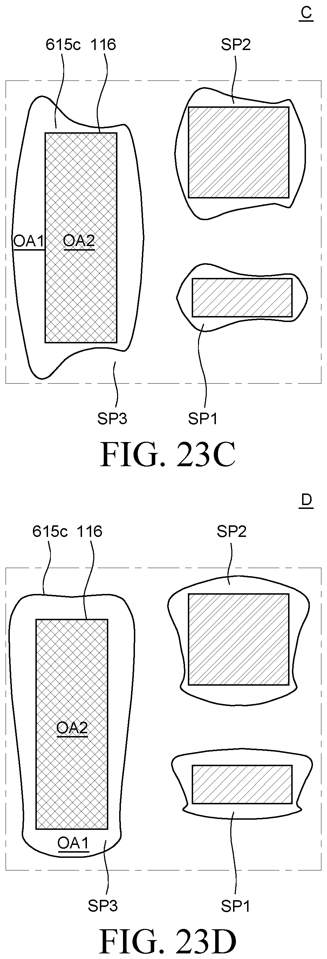

FIG. 23C illustrates a pixel structure in the part C of FIG. 22.

FIG. 23D illustrates a pixel structure in the part D of FIG. 22.

FIG. 22 shows a display device capable of side display as an example.

The display device according to the sixth embodiment shown in FIG. 22 and FIG. 23A through FIG. 23D is substantially the same as that of the above-described embodiments only except a pixel structure. Therefore, redundant description of the same components will be omitted. Hereinafter, description of the same reference numerals can refer to FIG. 1 through FIG. 21A and FIG. 21B.

Referring to FIG. 22 and FIG. 23A through FIG. 23D, an organic light emitting display device can be manufactured to be capable of side display. The organic light emitting display device capable of side display can be manufactured into a desired shape by bending a part of the display panel DISP to implement side emission.

In the organic light emitting display device capable of side display, a cover window 690 can be attached corresponding to the display panel DISP in order to suppress direct contact of the display panel DISP with the outside. As the display panel DISP is bent to implement side display, the cover window 690 configured to protect the display panel DISP can also need to be bent in the same manner as the display panel DISP. Further, a black matrix can be printed on the cover window 690 to cover line and circuit areas of the display panel DISP. A black matrix can be printed on the cover window 690 so as to correspond to the line and circuit areas of the display panel DISP.

The display panel DISP can include the active area AA in which images are displayed and the non-active area NA provided outside the active area AA. For example, the non-active area NA can be provided on at least one of the left and right sides of the active area AA and can be provided on the upper and lower sides of the active area AA. A plurality of sub-pixels can be disposed in the active area AA to display images. At this time, if the display device is an organic light emitting display device, a light emitting element can be disposed in each sub-pixel of the active area AA. If the display device is a liquid crystal display device, a liquid crystal layer and an alignment layer can be disposed in each sub-pixel of the active area AA.

The display device according to the present disclosure is made of a flexible material, such as plastic, and thus can be bent. A bending area BA can be located on at least one side of the display device. For example, the bending area BA includes a side area for side display. The bending area BA can include a first side area A located on the upper side of the display panel DISP and a second side area B located on the left side of the display panel DISP. Further, the bending area BA can include a third side area C located on the right side of the display panel DISP and a fourth side area D located on the lower side of the display panel DISP. Herein, the upper, lower, left and right sides of the display panel DISP refer to certain directions, and can refer to the upper, lower, left and right sides of the display device of FIG. 22 being rotated clockwise by 90°.

A plurality of sub-pixels SP1, SP2 and SP3 configured to display images can be disposed in the first side area A, the second side area B, the third side area C, and the fourth side area D.

For example, the first sub-pixel SP1 can be a red sub-pixel.

For example, the second sub-pixel SP2 can be a green sub-pixel.

For example, the third sub-pixel SP3 can be a blue sub-pixel.

For example, each of the first sub-pixel SP1, the second sub-pixel SP2, and the third sub-pixel SP3 can have a polygonal shape, such as a rectangular shape, but is not limited thereto.

Herein, the shape of the sub-pixels SP1, SP2 and SP3 can be defined by the shape of the second opening OA2. However, the present disclosure is not limited thereto.

As described above, a third planarization layer 615c can include the first opening OA1 provided by removing (opening) a portion corresponding to the main emission area, the reflective emission area, and the first non-emission area of the sub-pixels SP1, SP2 and SP3.

Further, in the sixth embodiment of the present disclosure, a side portion of the third planarization layer 615c in contact with a side surface of the anode having an SM structure has a shape that differs between its left and right sides and its upper and lower sides when viewed from the top. Thus, it is possible to improve the luminance viewing angle and the optical efficiency in a specific direction.

In particular, each of the sub-pixels SP1, SP2 and SP3 in the first side area A, the second side area B, the third side area C, and the fourth side area D for side display is bent. Thus, luminance viewing angle characteristics can change when an image is viewed at a normal viewing angle. Therefore, the luminance or color can be perceived as uneven.

Therefore, according to the fifth embodiment of the present disclosure, a distance between the side portion of the anode having an SM structure and the side portion of the bank 116 varies depending on a viewing angle direction within each of the sub-pixels SP1, SP2 and SP3. Thus, it is possible to improve the luminance viewing angle and the optical efficiency in a specific direction. Further, it is possible to control the luminance viewing angle and the optical efficiency according to the viewing angle direction.

For example, in the first side area A located on the upper side of the display panel DISP, it can be designed that a left and right width of the first opening OA1 of the sub-pixels SP1, SP2 and SP3 is the smallest on the upper side and gradually increases in the downward direction when viewed from the top. Further, an upper and lower width thereof is the greatest at the center and gradually decreases in the left and right direction when viewed from the top.

For example, in the second side area B located on the left side of the display panel DISP, it can be designed that a left and right width of the first opening OA1 of the sub-pixels SP1, SP2 and SP3 is the greatest at the center and gradually decreases in the upward and downward direction when viewed from the top. Further, an upper and lower width thereof is the smallest on the left side and gradually increases in the right direction when viewed from the top.

For example, in the third side area C located on the right side of the display panel DISP, it can be designed that a left and right width of the first opening OA1 of the sub-pixels SP1, SP2 and SP3 is the greatest at the center and gradually decreases in the upward and downward direction when viewed from the top. Further, an upper and lower width thereof is the smallest on the right side and gradually increases in the left direction when viewed from the top.

For example, in the fourth side area D located on the lower side of the display panel DISP, it can be designed that a left and right width of the first opening OA1 of the sub-pixels SP1, SP2 and SP3 is the smallest on the lower side and gradually increases in the upward direction when viewed from the top. Further, an upper and lower width thereof is the greatest at the center and gradually decreases in the left and right direction when viewed from the top.

The sub-pixels SP1, SP2 and SP3 of the first side area A, the second side area B, the third side area C, and the fourth side area D in the bending area BA are designed to compensate for a width of the first opening OA1 or a distance between the side portion of the anode and the side portion of the bank 116 (in consideration of a deviated luminance viewing angle when an image is viewed at a normal viewing angle). Thus, the luminance or color can be perceived as uniform.

Also, with reference to FIG. 4 and FIGS. 22-23D, a display device can include a display panel DISP including an active area AA and a bending area BA at a periphery of the active area AA. A plurality of first pixels can be in the active area AA and a plurality of second pixels can be in the bending area BA.

With reference to FIG. 4, each of the plurality of first pixels in the active area is symmetric about a first axis (line Ia-Ia) and a second axis (line Ib-Ib) that is perpendicular to the first axis.

With reference to FIGS. 22-23D, each of the plurality of second pixels in the bending area is symmetric about only one of a first axis and a second axis. In embodiments of the present disclosure, the first axis can be parallel to or be one of an x-axis and a y-axis, and the second axis can be parallel to or be the other of the x-axis and the y-axis.

Further, with reference to FIGS. 22-23D, the bending area BA includes a first side area (A of FIG. 23A or B of FIG. 23B) and a second side area (D of FIG. 23D or C of FIG. 23C) at opposite ends of the active area AA. In this context, shapes of the plurality of second pixels in the first side area (A of FIG. 23A or B of FIG. 23B) and shapes of the plurality of second pixels in the second side area (D of FIG. 23D or C of FIG. 23C) can be symmetric about the other of the first axis and the second axis.

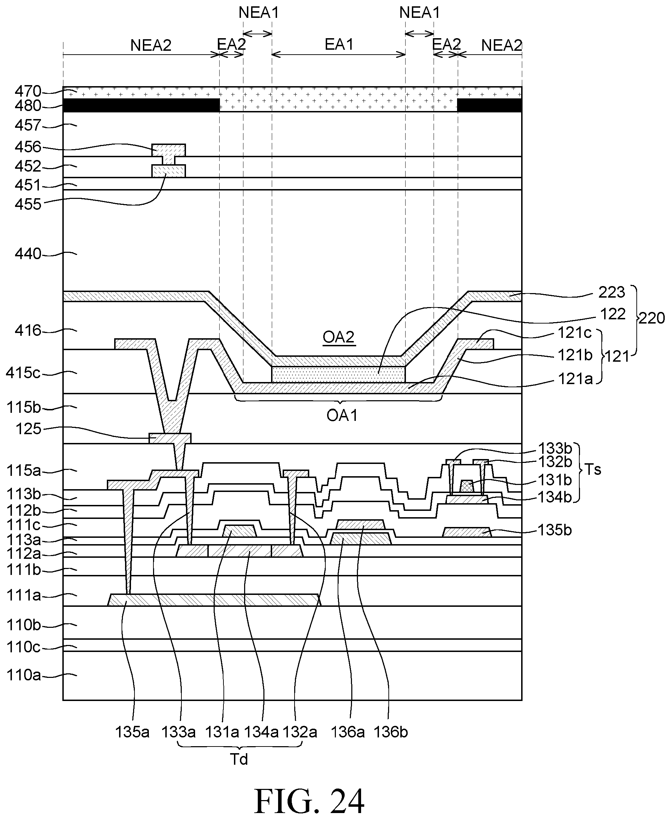

FIG. 24 is a partial cross-sectional view of the sub-pixel in the display panel according to another embodiment of the present disclosure.

The display panel according to the another embodiment of the present disclosure as shown in FIG. 24 is substantially the same as that of the embodiment shown in FIG. 16 and FIG. 17 except for slopes of the anode 121 and the cathode 223 of a light emitting diode 220, and shapes of the bank 416 at the second opening OA2. Therefore, redundant description of the same components will be omitted. Hereinafter, the description of the same reference numerals can refer to FIG. 16 and FIG. 17.

As shown in FIG. 24, a slope of the second area 121b of the anode 121 can be defined by the side surface of the third planarization layer 415c at the first opening OA1, and a slope of the cathode 223 at the second opening OA2 can be defined by the side surface of the bank 416. In various embodiments, the slopes of the anode 121 and the cathode 223 can be the same or different. For example, FIG. 24 shows that the slope of the second area 121b of the anode 121 can be greater than the slope of the cathode 223, but the disclosure is not limited thereto, as can be seen from FIG. 16 and FIG. 17, where the slope of the second area 121b of the anode is less than the slope of the cathode 223.

In addition, a sloped portion of the bank 416 can be interposed between the second area 121b of the anode 121 and the cathode 223 and can also be inclined. When the slopes of the second area 121b of the anode 121 and the cathode 223 are the same, a thickness of the sloped portion of the bank 416 can have a same thickness between a lower surface of the third planarization layer 415c and an upper surface of the bank 416. On the other hand, when the slopes of the second area 121b of the anode 121 and the cathode 223 are different, a thickness of the sloped portion of the bank 416 can vary. In FIG. 24, the thickness of the sloped portion of the bank 416 narrows in the middle when the slope of the second area 121b of the anode 121 is greater than the slope of the cathode 223, while the thickness of the sloped portion of the bank 416 widens in going from the lower surface of the third planarization layer 415c to the upper surface of the bank 416.

When the slopes of the second area 121b of the anode 121 and the cathode 223 are different, a distance between the second area 121b of the anode 121 and the cathode 223 can vary in going from the lower surface of the third planarization layer 415c to the upper surface of the bank 416.

In various embodiments, the slopes of the second area 121b of the anode 121 can vary even from the second area 121b of the anode 121 at another pixel, and the slope of the cathode 223 can vary from the slope of the cathode at another pixel.

With reference to FIG. 24, the slope (or an inclined portion) of the cathode 223 can extend from an edge of the first or main emission area EA1 to a level upper surface or a flat upper surface of the bank 416. In this regard, an end of the slope (or the inclined portion) of the cathode 223 at the level upper surface or the flat upper surface of the bank 416 can be located in the second non-emission area NEA2, but the present disclosure is not limited thereto. For example, the end of the slope (or the inclined portion) of the cathode 223 at the level upper surface or the flat upper surface of the bank 416 can be located in the first non-emission area NEA1 or the second emission area EA2. In embodiments of the present disclosure, one end of the slope (or the inclined portion) of the cathode 223 at the level upper surface or the flat upper surface of the bank 416 can be located in one of the first non-emission area NEA1, the second emission area EA2 and the second non-emission area NEA2, and another end of the of the slope (or the inclined portion) of the cathode 223 at the level upper surface or the flat upper surface of the bank 416 can be located in another of the first non-emission area NEA1, the second emission area EA2 and the second non-emission area NEA2.

The example embodiments of the present disclosure can also be described as follows:

According to a first aspect of the present disclosure, a display device includes a substrate including a plurality of sub-pixels; a planarization layer disposed on the substrate and including a first opening; an anode disposed in the first opening and on a side portion of the planarization layer in the first opening; a bank covering a part of the anode and including a second opening; an organic layer exposed through the second opening and disposed on the anode; and a cathode disposed on the organic layer. A shape of the first opening may be different from that of the second opening.

A separation distance between a portion of the anode disposed on the side portion of the planarization layer and a side portion of the bank exposed through the second opening may vary based on a location within at least one sub-pixel of the plurality of sub-pixels.

According to a second aspect of the present disclosure, a display device includes a substrate including a plurality of sub-pixels; a planarization layer disposed on the substrate and defining a first opening; an anode having a first area disposed in the first opening and a second area on a side portion of the planarization layer facing the first opening; a bank covering the second area of the anode and defining a second opening that includes a first emission area; an organic layer disposed on the first area of the anode; and a cathode disposed on the organic layer and on a side portion of the bank facing the second opening, wherein a first separation distance between the second area of the anode and the first emission area in a first direction of at least one sub-pixel of the plurality of the sub-pixels is different from a second separation distance between the second area of the anode and the first emission area in a second direction of at least one sub-pixel, the second direction being different from the first direction.

According to a third aspect of the present disclosure, a display device includes a display panel including an active area and a bending area at a periphery of the active area; and a plurality of first pixels in the active area and a plurality of second pixels in the bending area, wherein each of the plurality of first pixels in the active area is symmetric about a first axis and a second axis that is perpendicular to the first axis, and wherein each of the plurality of second pixels in the bending area is symmetric about only one of the first axis and the second axis.

The display device according to any one of these aspects may include one or more of the following features:

The planarization layer disposed on the substrate may be disposed on the sub-pixels.

The anode may include a (first) portion disposed within the first opening of the planarization layer. The anode may include a (second) portion on the side portion of the planarization layer. The bank may cover the (second) portion on the side portion of the planarization layer. The bank may include a plurality of second openings, each defining a main emission area of one of the plurality of sub-pixels.

The term "thickness" may denote a dimension in a direction perpendicular to the substrate. The term "width" may denote a dimension in a direction parallel to the substrate.

A (separation) distance between a portion the anode disposed on the side portion of the planarization layer and a side portion of the bank exposed through the second opening may vary or depend based on a location within the at least one sub-pixel of the plurality of sub-pixels and/or based on a location along a circumference of the second opening. The separation distance may be in a range of approximately 1.5 um to 4.0 um.

The (separation) distance may be defined along a direction parallel to the substrate.

The area within the second opening may be denoted as main emission area. Thus, the second opening may define or delimit the main emission area.

The anode may include a first portion disposed within the first opening, a second portion disposed on the side portion of the planarization layer and a third portion disposed on an upper or top surface of the planarization layer.

At least one of a width and an area of the first opening may be equal to or greater than that of the second opening. A width of the first opening may be equal to or greater than a width of the second opening, and/or an area of the first opening may be equal to or greater than an area of the second opening. The width may denote any distance from one side to the other of the opening, the distance crossing a center of the opening.

At least one sub-pixel of the plurality of sub-pixels may include a separation distance between a portion the anode disposed on the side portion of the planarization layer and a main emission area of the at least one sub-pixel that varies within the at least one sub-pixel.

The separation distance may include a first separation distance between the portion of the anode on the side portion of the planarization layer and the main emission area at a center of the at least one sub-pixel in a first direction. The first separation distance may be smaller than a second separation distance between the portion of the anode and the main emission area at the center of the at least one sub-pixel in a second direction different from the first direction.

A first separation distance between the (second) portion of the anode on the side portion of the planarization layer and the side portion of the bank exposed through the second opening in a first direction passing through a center of the second opening may be smaller than a second separation distance between said (second) portion of the anode and the side portion of the bank in a second direction passing through a center of the second opening, the second direction being different from the first direction. The first and second direction may be perpendicular to each other.

The first separation distance may gradually increase in the second direction.

The second separation direction may gradually decrease in the first direction.

A slope, or an inclination with respect to the substrate, of the anode disposed on the side portion of the planarization layer may be equal to or less than a slope, or an inclination with respect to the substrate, of the cathode disposed on a side portion of the bank. The side portion of the bank may be adjacent to the second opening and/or define the second opening.

A slope of the anode disposed on the side portion of the planarization layer may be greater than a slope of the cathode disposed on a side portion of the bank. The slope may be defined with respect to the substrate.

The anode may include or realizes a side mirror structure.

A separation distance between the anode having the side mirror structure and a main emission area may vary within each sub-pixel of the plurality of sub-pixels.

The display device may further include an encapsulation unit on the cathode. The display device may further include a color filter layer and a black matrix disposed on the encapsulation unit.

The display device may further include a main or first emission area in a sub-pixel of the plurality of subpixels. The main emission area may be corresponding to the second opening.

The sub-pixel may include a first non-emission area surrounding the main emission area.

The sub-pixel may include a first non-emission area surrounding the main emission area. A width of the first non-emission area may vary in at least a/the first direction and a/the second direction that is different from the first direction.

The sub-pixel may incude a second (or reflective) emission area surrounding the main emission area. The second emission area may surround the first non-emission area. The first non-emission area and the second emission area may be arranged concentrically with the main emission area. The second emission area may include a first area having a first width, and a second area having a second with. An amount of light from the first area may be different from an amount of light from the second area.

The bank may be interposed between the anode and the cathode at the first opening. The bank may include a sloped portion. A thickness or width of the sloped portion of the bank may vary in at least a first direction and a second direction that is different from the first direction.

The first non-emission area may further include at least one of an inwardly concave shape and an outwardly convex shape.

The first non-emission area may have the inwardly concave shape in a first direction of the sub-pixel, and/or may have the outwardly convex shape in a second direction of the sub-pixel, the second direction being different from the first direction.

The sub-pixel may include a second emission area surrounding the first non-emission area. The second emission area may have a polygonal annular shape.

The second emission area may further include at least one of an inwardly concave shape and an outwardly convex shape.

The second emission area may have the inwardly concave shape in a first direction of the sub-pixel, and/or may have the outwardly convex shape in a second direction of the sub-pixel, the second direction being different from the first direction.

The bank may be interposed between the anode and the cathode at the first opening. The bank may include a sloped portion. The sloped portion may have a thickness in a direction perpendicular to the substrate, the thickness varying in a direction passing through the center of the second opening (and being parallel to the substrate). The sloped portion may have a linear slope (e.g. with respect to the substrate).

A slope of the sloped portion of the bank may be larger than a slope of the portion of the anode on the side portion of the planarization layer. A thickness of the sloped portion of the bank may increase in a direction away from the center of the second opening.

A slope of the sloped portion of the bank may be smaller than a slope of the portion of the anode on the side portion of the planarization layer. A thickness of the sloped portion of the bank may first increase and then decrease in a direction away from the center of the second opening. The thickness of the sloped portion of the bank may increase from the second opening to the portion of the anode on the side portion of the planarization layer. The thickness of the sloped portion of the bank may decrease from a first end of the portion of the anode on the side portion of the planarization layer (i.e. from a point where the portion of the anode disposed within the first opening and the portion of the anode disposed on the side portion of the planarization layer meet) to a second end of the portion of the anode on the side portion of the planarization layer (i.e. to a point where the portion of the anode disposed on the side portion of the planarization layer and a portion of the anode disposed on an upper surface of the planarization layer meet), in a direction away from the center of the second opening.

A thickness of the sloped portion of the bank may vary between a lower surface of the planarization layer and an upper surface of the bank.

The thickness of the sloped portion of the bank may narrow in a middle portion thereof.

The thickness of the sloped portion of the bank may widen in a direction from the lower surface of the planarization layer to the upper surface of the bank.

The display device, in particular the display device according to the second aspect, may include a second emission area that surrounds the first emission area.

The display device, in particular the display device according to the second aspect, may include a non-emission area interposed between the first emission area and the second emission area.

The display device may include a bending area at a periphery of an active area of the display device, the active area including a plurality of first pixels the bending area including a plurality of second pixels. Each of the first pixels may be symmetric about two axis (the first and the second axis) being perpendicular to each other. Each of the second pixels may be symmetric about (only) one axis (e.g. only one of the first and the second axis). The bending area may include a first side area and a second side area at opposite ends of the active area. Shapes of the plurality of second pixels in the first side area and shapes of the plurality of second pixels in the second side area may be symmetric about the other of the first axis and the second axis.

Although the example embodiments of the present disclosure have been described in detail with reference to the accompanying drawings, the present disclosure is not limited thereto and can be embodied in many different forms without departing from the technical concept of the present disclosure. Therefore, the example embodiments of the present disclosure are provided for illustrative purposes only but not intended to limit the technical concept of the present disclosure. The scope of the technical concept of the present disclosure is not limited thereto. Therefore, it should be understood that the above-described example embodiments are illustrative in all aspects and do not limit the present disclosure. All the technical concepts in the equivalent scope of the present disclosure should be construed as falling within the scope of the present disclosure.

## Claims

1. A display device comprising:
a substrate (110) including a plurality of sub-pixels (SP1, SP2, SP3);
a planarization layer (115c) disposed on the substrate (110) and including a first opening (OA1);
an anode (121) disposed in the first opening (OA1) and on a side portion of the planarization layer (115c) surrounding the first opening (OA1);
a bank (116) covering a part of the anode (121) and including a second opening (OA2);
an organic layer (122) exposed through the second opening (OA2) and disposed on the anode (121); and
a cathode (123) disposed on the organic layer (122),
wherein a shape of the first opening (OA1) is different from that of the second opening (OA2).

2. The display device of claim 1, wherein a separation distance (d1) between a portion (121b) of the anode (121) disposed on the side portion of the planarization layer (115c) and a side portion of the bank exposed through the second opening (OA2) varies based on a location along a circumference of the second opening (OA2).

3. The display device of claim 2, wherein the separation distance (d1, d2) is in a range of approximately 1.5 µm to 4.0 µm.

4. The display device according to any one of the preceding claims, wherein at least one of a width and an area of the first opening (OA1) is equal to or greater than the corresponding one of the second opening (OA2).

5. The display device according to any one of the preceding claims, wherein a first separation distance (d1) between the portion (121b) of the anode (121) on the side portion of the planarization layer (115c) and the side portion of the bank (116) exposed through the second opening (OA2) in a first direction passing through a center of the second opening (OA2) is smaller than a second separation distance (d2) between said portion (121b) of the anode (121) and the side portion of the bank (116) in a second direction passing through a center of the second opening (OA2), the second direction being different from the first direction.

6. The display device of claim 5, wherein the first separation distance (d1) gradually increases in the second direction, and/or
wherein the second separation distance (d2) gradually decreases in the first direction.

7. The display device according to any one of the preceding claims, further comprising:
an encapsulation unit (440) on the cathode (123); and
a color filter layer (480) and a black matrix (470) disposed on the encapsulation unit (440).

8. The display device according to any one of the preceding claims, wherein the bank (116) includes a plurality of second openings (OA2), and each sub-pixel of the plurality of subpixels comprises a main emission area (EA1) corresponding to one of the plurality of second openings (OA2).

9. The display device of claim 8, wherein each sub-pixel of the plurality of subpixels includes a first non-emission area (NEA1) surrounding the main emission area (EA1),
wherein a width of the first non-emission area (NEA1) varies in at least one of a first direction and a second direction that is different from the first direction.

10. The display device of claim 8 or 9, wherein each sub-pixel of the plurality of subpixels incudes a reflective emission area (EA2) surrounding the main emission area (EA1), and wherein
the reflective emission area (EA2) includes a first area having a first width, and a second area having a second width, the first width and the second width being different from each other, and/or
an amount of light from the first area of the reflective emission area (EA2) is different from an amount of light from the second area of the reflective emission area (EA2).

11. The display device of claim 10, wherein the reflective emission area (EA2) has a polygonal annular shape, or
wherein the reflective emission area (EA2) has at least one of an inwardly concave shape and an outwardly convex shape. or wherein the reflective emission area (EA2) has an inwardly concave shape in a first direction, and/or an outwardly convex shape in a second direction, the second direction being different from the first direction.

12. The display device of claim 9, 10 or 11, wherein the first non-emission area (NEAT) further includes at least one of an inwardly concave shaped portion and an outwardly convex shaped portion, in a plan view; or
wherein the first non-emission area has an inwardly concave shaped portion in a first direction passing through a center of the second opening (OP2), and/or an outwardly convex shape in a second direction passing through a center of the second opening (OP2), the second direction being different from or perpendicular to the first direction.

13. The display device according to any one of the preceding claims, wherein the bank (116) is interposed between the anode (121) and the cathode (123) at the first opening (OP1), and includes a sloped portion.

14. The display device of claim 13, wherein a slope of the sloped portion of the bank (116) is larger than a slope of the portion (121b) of the anode (121) on the side portion of the planarization layer (115c); and/or
wherein a thickness of the sloped portion of the bank (116) increases in a direction away from the center of the second opening (OP2).

15. The display device of claim 13, wherein a slope of the sloped portion of the bank (116) is smaller than a slope of the portion (121b) of the anode (121) on the side portion of the planarization layer (115c); and/or
wherein a thickness of the sloped portion of the bank (116) increases from the second opening (OP2) to the portion of the anode (121) on the side portion of the planarization layer (115c) and/or decreases from a first end of the portion (121b) of the anode (121) on the side portion of the planarization layer (115c) to a second end of the portion of the anode (212) on the side portion of the planarization layer (115c), in a direction away from the center of the second opening (OP2).
